# EUROPÄISCHE PATENTSCHRIFT

(11) **EP 2 732 538 B1**
(45) Veröffentlichungstag und Bekanntmachung des Hinweises auf die Patenterteilung: **22.07.2015**
(21) Anmeldenummer: 12728267.1
(22) Anmeldetag: 18.06.2012
(51) Int. Cl.: H02K 35/02, G08C 17/00, H01H 5/02

(54) **INDUKTIONSGENERATOR**
INDUCTION GENERATOR
GÉNÉRATEUR À INDUCTION

(30) Priorität: 11.07.2011 DE 102011078932
(43) Veröffentlichungstag der Anmeldung: 21.05.2014
(73) Patentinhaber: ZF Friedrichshafen AG, 88038 Friedrichshafen (DE)
(72) Erfinder: RUFF, Eduard, 91275 Auerbach (DE)
(86) Internationale Anmeldenummer: PCT/EP2012/061542
(87) Internationale Veröffentlichungsnummer: WO 2013/007474

(56) Entgegenhaltungen:
- EP-A1- 0 836 166
- DE-A1- 19 852 470
- JP-A- 2005 151 750
- US-A1- 2003 155 828
- US-A1- 2011 133 975

## Beschreibung

Die vorliegende Erfindung betrifft einen Induktionsgenerator für einen Funkschalter gemäß dem Oberbegriff von Anspruch 1, insbesondere für einen Miniaturschnappschalter.

Im Stand der Technik sind zahlreiche Induktionsgeneratoren vorgeschlagen worden, welche wie vorliegend zur Verwendung in einem energieautarken Funkschalter einsetzbar sind.

Die DE 103 15 765 A1 zeigt einen elektromagnetischen Energiewandler, bei welchem ein von einer Spule umschlossenes Element relativ zu einem Permanentmagneten bewegt werden kann, wobei in einer ersten und einer zweiten Ruhelage der magnetische Fluss durch das bewegliche Element jeweils geschlossen ist. Der Energiewandler ist derart ausgebildet, dass infolge einer um eine Achse geführte Kippbewegung des beweglichen Elements der magnetische Fluss in der Spule umgekehrt wird.

Die DE 198 52 470 A1 zeigt ein Energieerzeugungssystem, bei welchem an einer Tragschiene angeordnete, mit wechselnder Polarität gereihte Dauermagneten in einem Schwingkreis an einer Induktionsspulenanordnung vorbeibewegt werden, wobei zwischen den Dauermagneten und der Induktionsspulenanordnung ein Luftspalt vorgesehen ist.

Die US 2011 013 3975 A1 offenbart einen Induktionsgenerator mit einem mechanischen Gleitkontaktabschnitt, welcher nicht magnetisierbar ist.

Um einen Funkschalter wie vorliegend miniaturisierbar auszubilden, muss regelmäßig trotz einer kleinen Baugröße des Induktionssystems eine hohe elektrische Energie aus dem mechanischen Betätigungsvorgang des Schalters generiert werden. Dazu muss der Umschaltvorgang bekanntermaßen möglichst schnell (sprunghaft) erfolgen. Das bewegliche Element ist demnach schnell zu beschleunigen und entsprechend stark abzubremsen. Dabei kann es zu einem mechanischen Prellen kommen, das zu Gegeninduktionseffekten und damit zu Energieverlusten sowie zu Festigkeitsproblemen im Funkschalter führen kann. Ferner werden durch den Umschaltvorgang akustische Geräusche erzeugt werden, die je nach Anwendung des Funkschalters nicht erwünscht sind. Weiterhin ist ein entsprechend großer Betätigungskraftaufwand notwendig, um einen Umschaltvorgang mittels Trennung zwischen Magnetelement und Spulenkern bei einem Wechsel zwischen den eine Induktionsspannung erzeugende Ruhestellungen zu erreichen. Die bekannten Lösungen sind demnach verbesserungsfähig.

Mit dem gemäß dem Patentanspruch 1 vorgeschlagenen Induktionsgenerator sollen die vorbeschriebenen Probleme begegnet werden. Der Induktionsgenerator umfasst ein Magnetelement und einen Spulenkern. Unter einem Magnetelement wird eine Komponente verstanden, die wenigstens einen Permanentmagneten mit an dem Nordpol und Südpol kontaktierbaren Abschnitten, welche Punkte, Linien oder Flächen sein können, umfasst. Diese Abschnitte werden im Folgenden als Nordpolkontaktabschnitt und Südpolkontaktabschnitt bezeichnet. Über diese Abschnitte ist mittels magnetischen Kontakts mit denselbigen ein Magnetfluss generierbar. Dazu ist der Spulenkern vorgesehen, der aus einem magnetisierbaren Material wie Eisen oder ähnlichem ausgebildet ist. Der Spulenkern umfasst wenigstens zwei Polkontaktabschnitte, die mit dem Nordpolkontaktabschnitt und dem Südpolkontaktabschnitt kontaktierbar angeordnet sind. Vorzugsweise ist der Spulenkern U-förmig ausgebildet. Im Sinne der vorliegenden Erfindung sind unter einer U-Form jegliche Ausgestaltungen zu verstehen, die wenigstens zwei in gleiche Richtung weisende Polkontaktabschnitte aufweisen. So fallen unter eine U-Form vorzugsweise auch C- und V-förmige Ausführungsformen. Weiter bevorzugt umfasst der Spulenkern wenigstens drei im Wesentlichen in eine gleiche Richtung weisende Polkontaktabschnitte auf. Der Spulenkern kann hierbei weiter bevorzugt beispielsweise E- oder W-förmig ausgestaltet sein.

Mittels gleichzeitigen Kontakts eines Polkontaktabschnittes mit dem Nordpolkontaktabschnitt und des anderen Polkontaktabschnittes mit dem Südpolkontaktabschnitt wird ein zwischen dem Nordpol und dem Südpol des Magnetelementes verlaufender Magnetfluss über den Spulenkern generiert. Um eine Induktionsspannung erzeugen zu können, ist eine Magnetflussrichtungsumkehr notwendig. Daher sind der Spulenkern und das Magnetelement zueinander relativ beweglich angeordnet. Mit anderen Worten kann der Spulenkern oder das Magnetelement beweglich vorgesehen sein. Alternativ können sowohl der Spulenkern als auch das Magnetelement beweglich angeordnet sein. Die Anordnung erfolgt vorzugsweise in einer Halterung, welche ein Gehäuse beispielsweise eines Funkschalters, für welchen der Induktionsgenerator vorzugsweise vorgesehen ist, sein kann. Entsprechend können der Spulenkern und das Magnetelement Einrichtungen aufweisen, die ein Zusammenwirken mit der Halterung derart ermöglichen, dass entweder der Spulenkern oder das Magnetelement oder wahlweise eines dieser Komponenten oder beide Komponenten gleichzeitig bewegbar sind, wodurch die zueinander relative Bewegung erzeugbar ist. Im Einzelnen sind der Spulenkern und das Magnetelement wenigstens zwischen einer ersten Ruhestellung und einer zweiten Ruhestellung zueinander relativ beweglich angeordnet. Die Bewegung des Spulenkerns und/oder des Magnetelementes erfolgt vorzugsweise über einen mit dem Spulenkern oder Magnetelement koppelbaren Betätiger, der wenigstens manuell oder maschinell gesteuert betätigbar ist und die beim Betätigen ausgeübte Betätigungskraft auf den Spulenkern bzw. den Magnetelementen zur Erzwingung der Relativbewegung überträgt. Der sprunghafte Wechsel von einer in die andere Ruhestellung kann vorzugsweise in Abhängigkeit der Betätigungsgeschwindigkeit erfolgen. Weiter bevorzugt entspricht die Betätigungsgeschwindigkeit der Wechselgeschwindigkeit, mit welcher der Wechsel von der einen in die andere Ruhestellung erfolgt. Dies kann beispielsweise über eine direkte Koppelbarkeit des Spulenkerns oder des Magnetelementes mit dem Betätiger erreicht werden.

In der jeweiligen Ruhestellung wird ein Magnetfluss zwischen Spulenkern und Magnetelement erzeugt, wobei der erzeugte Magnetfluss in einer der Ruhestellungen in einer entgegengesetzten Richtung als der erzeugte Magnetfluss in der anderen der Ruhestellungen verläuft. Durch die vorzugsweise sprunghaft erzeugte Magnetflussrichtungsumkehr kann auf übliche Weise in dem Spulenkern eine Spulenumkehrpolung erzeugt werden, die im Zusammenwirken mit einer den Spulenkern vorzugsweise umgebenden Induktionsspule zu einer Induktionsspannung führt. Es können auch mehr als zwei Ruhestellungen vorgesehen sein. Bevorzugt wird für diesen Fall eine Anordnung derart, dass bei einem Wechsel zwischen zwei benachbarten Ruhestellungen eine Spulenumkehrpolung zur Erzeugung einer Induktionsspannung erreicht werden kann.

Das Magnetelement mit seinem Nordpol- und Südpolkontaktabschnitt ist zur Erzeugung des Magnetflusses über den Spulenkern entsprechend ausgeformt. Um einen Wechsel zwischen den wenigstens zwei Ruhestellungen mit einer damit einhergehenden Magnetflussrichtungsumkehr in einem möglichst kompakt ausgebildeten Induktionsgenerator ermöglichen zu können, weist das Magnetelement mit Blick auf einen beispielhaften Spulenkern umfassend zwei Polkontaktabschnitte, vorzugsweise zwei Nordpolkontaktabschnitte, die einen Südpolkontaktabschnitt einfassen oder zwei Südpolkontaktabschnitte, die einen Nordpolkontaktabschnitt einfassen, auf. Die jeweiligen beiden Südpol- bzw. Nordpolkontaktabschnitte können vorzugsweise über einen in Anlage mit dem entsprechenden Pol des Permanentmagneten angeordneten U-förmigen Polschuh realisiert werden. Die jeweiligen Schenkel des Polschuhs fassen den Permanentmagneten ein, wobei der freie Pol des Permanentmagneten vorzugsweise in Anlage mit einem weiteren Polschuh ist, der den anderen der beiden Südpol- bzw. Nordpolkontaktabschnitt des Magnetelements ausbildet. Die Polkontaktabschnitte des Spulenkerns sowie des Magnetelements sind vorzugsweise jeweils parallel zu der Relativbewegungsrichtung angeordnet. Weiter bevorzugt sind die von den jeweiligen Pol- und Südpol- bzw. Nordpolkontaktabschnitte ausgebildeten Kontaktflächen jeweils in einer gemeinsamen Ebene angeordnet.

In einer alternativen bevorzugten Ausführungsform mit Blick auf einen E- oder W-förmigen Spulenkern weist das Magnetelement vorzugsweise einen Nordpolkontaktabschnitt und einen Südpolkontaktabschnitt auf, die derart angeordnet sind, dass diese mit den wenigstens drei Polkontaktabschnitten des Spulenkerns in den wenigstens zwei Ruhestellungen zur Magnetflussrichtungsumkehr in Kontakt bringbar sind. Beispielsweise kann das Magnetelement hierfür eine U-Form aufweisen, wobei vorzugsweise die jeweiligen freien Enden der Schenkel der U-Form den Nordpolkontaktabschnitt und den Südpolkontaktabschnitt ausbilden, Der Grund der U-Form kann weiter bevorzugt durch den Permanentmagneten ausgebildet werden.

Der Induktionsgenerator weist des Weiteren einen Gleitkontaktabschnitt auf, der sich parallel zu einer Bewegungsrichtung des Spulenkerns und/oder des Magnetelements, im Folgenden der bewegbaren Komponente erstreckt. Die Bewegungsrichtung bzw. die Richtung der Relativbewegung wird durch die Anordnung der Ruhestellungen vorgegeben. Demnach verläuft die Bewegungsrichtung der bewegbaren Komponente parallel zu einer Bewegungslinie zwischen den Ruhestellungen, entlang welcher Bewegungslinie die bewegbare Komponente bewegbar ist.

Der Gleitkontaktabschnitt ist aus einem magnetisierbaren Material ausgebildet. Der Gleitkontaktabschnitt kann vorzugsweise aus mehreren punktartigen, einer oder mehreren linien- und/oder flächenartigen Gleitkontaktflächen ausgebildet sein. Vorzugsweise überdeckt die Gleitkontaktfläche wenigstens 100 % wenigstens einer von dem Polkontaktabschnitt oder dem zugeordneten Nordpol- bzw. Südpolkontaktabschnitt jeweils ausgebildeten Kontaktfläche, die als den jeweiligen Kontaktabschnitt zugeordnete Durchlassfläche für den Magnetfluss in der jeweiligen Ruhestellung vorgesehen ist. Weiter bevorzugt überdeckt die Gleitkontaktfläche die Durchlassfläche zu mehr als 100 %. Mit anderen Worten überragt die Gleitkontaktfläche die Durchlassfläche wenigstens auf einer ihrer Seite in Relativbewegungsrichtung und/oder quer dazu. Dadurch kann in der jeweiligen Ruhestellung der Magnetfluss bzw. die Flussdichte zwischen Spulenkern und Magnetelement weiter verbessert werden.

Mit dem Gleitkontaktabschnitt ist die Relativbewegung zwischen dem Spulenkern und dem Magnetelement gleitend führbar. Eine Führung im Sinne der vorliegenden Erfindung liegt vor, wenn die bewegbare Komponente in Bewegungsrichtung entlang dem Gleitkontaktabschnitt bzw. der Gleitkontaktfläche bewegbar ist.

Unter einer gleitenden Führung ist eine entlang der Relativbewegung bzw. in Bewegungsrichtung der bewegbaren Komponente den Gleitkontaktabschnitt kontaktierende Bewegung der bewegbaren Komponente zu verstehen. Mit anderen Worten ist der Spulenkern und/oder das Magnetelement während einer Relativbewegung entlang des Gleitkontaktabschnittes, insbesondere entlang der Gleitkontaktfläche gleitend führbar. Der Gleitkontaktabschnitt ist vorzugsweise dergestalt, dass die bewegbare Komponente während der Relativbewegung an der Gleitkontaktfläche des Gleitkontaktabschnitts anliegt bzw. magnetisch mit dem Gleitkontaktabschnitt vorzugsweise unmittelbar, d.h. ohne zwischenliegenden Luftspalt mit Ausnahme von Fertigungs- bzw. Toleranzbedingtem Luftspalt verbunden ist. Solche Fertigungs- bzw. Toleranzbedingte Luftspalte zwischen sich kontaktierenden Kontaktflächen lassen sich nicht gänzlich vermeiden und sind vorzugsweise als inhärent mit einer gleitenden Führung zu verstehen. Durch die gleitende Führung wird gewährleistet, dass das Magnetelement mit dem Spulenkern während des Wechsels zwischen den Ruhestellungen in magnetischen Kontakt verbleibt. Damit kann die Betätigungskraft zur Durchführung des Wechsels verringert werden, da eine vollständige Trennung des Magnetelementes von dem Spulenkern vermeidbar ist. Im Einzelnen ist für eine entgegen der Anziehungskraft gerichtete Trennung wenigstens eine der Anziehungskraft gleiche oder größere Betätigungskraft notwendig. Durch die gleitende Führung, also die mittels des Gleitkontaktabschnitts während der Relativbewegung bestehende Kontaktierung zwischen Magnetelement und Spulenkern reduziert sich die für den Wechsel zwischen den Ruhestellungen benötigte Betätigungskraft um ein erhebliches. Vorzugsweise erstreckt sich der Gleitkontaktabschnitt, insbesondere die Gleitkontaktfläche rechtwinklig zur Wirkungsrichtung der zwischen dem Magnetelement und dem Spulenkern wirkenden Anziehungskraft. Mit anderen Worten erstreckt sich der Gleitkontaktabschnitt vorzugsweise rechtwinklig zu der zwischen dem Polkontaktabschnitt und dem zugeordneten Nordpol- oder Südpolkontaktabschnitt ausgebildeten Kontaktfläche. Die für den Wechsel zwischen den Ruhestellungen benötigte Betätigungskraft kann damit auf einen Betrag von maximal 30 %, vorzugsweise auf einen Betrag in einem Bereich von 20 % bis 30 % der Anziehungskraft reduziert werden. Dadurch kommt es bei dem Wechsel zwischen den Ruhestellungen nicht mehr zu einem sonst üblichen mechanischen Prellen, bei dem das Magnetelement und der Spulenkern kurzzeitig magnetisch getrennt werden, um kurz darauf wieder aufeinander zu treffen, wodurch erneut ein magnetischer Kontakt hergestellt wird. Damit können Festigkeitsprobleme und Energieertragsverluste begegnet werden. Ferner kann mit dem vorbeschriebenen Induktionsgenerator ein Betätigungsfreiheitsgrad erhöht, da ein von dem Induktionsgenerator erzeugbarer Energieertrag wahlweise abhängig von der Betätigungsgeschwindigkeit des mit der bewegbaren Komponente koppelbaren Betätigers oder unabhängig davon, also mit einer vordefinierten Betätigungsgeschwindigkeit vorbestimmbar, erzielbar ist. Zusätzlich wird mit dem vorbeschriebenen Induktionsgenerator eine Anpassung durch wahlweise vorbestimmtes Verstärken oder Unterdrücken einer Haptik zur Wahrnehmung des Umschaltvorganges und des üblicherweise erzeugten akustischen Geräusches möglich. Darüber hinaus können durch den modularen Aufbau des Induktionsgenerators im Bedarfsfall einzelne Komponenten wie beispielsweise der Spulenkern, das Magnetelement oder ein den Gleitkontaktabschnitt aufweisende Komponente auf einfache Art und Weise ausgetauscht werden. Zudem kann eine durch die Anordnung der Komponenten des Induktionsgenerators bedingte Toleranzkette verringert werden.

Die vorgenannten und weiteren Effekte werden in Verbindung mit den mit den Unteransprüchen angegebenen bevorzugten Ausführungsformen erläutert.

Nach einer bevorzugten Ausführungsform gemäß dem Patentanspruch 2 kontaktiert der Gleitkontaktabschnitt wenigstens in der Zwischenstellung gleichzeitig den Nordpolkontaktabschnitt und den Südpolkontaktabschnitt. Mit anderen Worten weist der Gleitkontaktabschnitt eine einem Abstand zwischen dem Nordpolkontaktabschnitt und dem Südpolkontaktabschnitt entsprechende Erstreckung auf. Damit kann die gleitende Führung der Relativbewegung bei dem Wechsel zwischen den Ruhestellungen weiter verbessert werden, da ein zwischen dem Nordpolkontaktabschnitt und dem Südpolkontaktabschnitt ausgebildeter Zwischenraum unter Beibehaltung des magnetischen Kontakts gleitend geführt überwunden werden kann.

Gemäß einer weiteren bevorzugten Ausführungsform mit den Merkmalen des Patentanspruchs 3 wird der Gleitkontaktabschnitt wenigstens von dem Polkontaktabschnitt des Spulenkerns ausgebildet. Damit braucht keine weitere Komponente außer dem Spulenkern und dem Magnetelement vorgesehen werden, um die gleitende Führung der Relativbewegung zu erreichen. Der Aufbau des Induktionsgenerators kann dadurch einfach gehalten bleiben. Diese Ausführungsform bedingt aber, dass alle Komponenten des Spulenkerns und des Magnetelementes sehr genau zueinander zu positionieren sind.

Nach einer bevorzugten Ausführungsform mit den Merkmalen des Patentanspruchs 4 bildet der Gleitkontaktabschnitt eine gleitende Führung für das Magnetelement aus, da sich der Gleitkontaktabschnitt wenigstens teilweise über einen zwischen benachbarten Polkontaktabschnitten des Spulenkerns ausgebildeten Zwischenraum erstreckt. Weiter bevorzugt weist der Gleitkontaktteilabschnitt in Relativbewegungsrichtung eine dem Abstand zwischen dem Nordpolkontaktabschnitt und dem Südpolkontaktabschnitt entsprechende Erstreckung ab dem Polkontaktabschnitt auf. Damit kann gleichfalls der zwischen dem Nordpolkontaktabschnitt und dem Südpolkontaktabschnitt ausgebildete Zwischenraum unter Beibehaltung des magnetischen Kontakts gleitend geführt überwunden werden, wodurch sich die gleitende Führung der Relativbewegung wie vorbeschrieben weiter verbessern lässt.

Mit der gemäß dem Patentanspruch 5 weiterhin bevorzugten Ausführungsform kann das Gleitkontaktelement auf einfache Art und Weise an dem Polkontaktabschnitt befestigt werden. Das Gleitkontaktelement kann den Polkontaktabschnitt an gegenüberliegenden Seiten, oder weiter bevorzugt vollumfänglich einfassen. Dabei kann sich das Gleitkontaktelement vorzugsweise auf der dem zwischen zwei benachbarten Polkontaktabschnitten ausgebildeten Zwischenraum abgewandten Seite des Polkontaktabschnittes wenigstens um einen dem Ausmaß des Nordpolkontaktabschnittes bzw. dem Südpolkontaktabschnittes in Bewegungsrichtung entsprechenden Betrag überragen. Damit kann das Magnetelement zuverlässig während des Wechsels zwischen den Ruhestellungen unter Beibehaltung des magnetischen Kontakts zwischen dem Spulenkern und dem Magnetelement gleitend geführt werden.

Gemäß einer bevorzugten alternativen Ausführungsform mit den Merkmalen des Patentanspruchs 6 bildet das Gleitkontaktelement eine gleitende Führung für den Spulenkern aus, wobei die gleitende Führung des Spulenkerns verbessert werden kann, da der Zwischenraum zwischen dem Nordpolkontaktabschnitt und dem Südpolkontaktabschnitt von dem Spulenkern unter Beibehaltung des magnetischen Kontakts gleitend geführt überwunden werden kann. Weiter bevorzugt umfasst das Gleitkontaktelement eine Aussparung zur Einfassung des Nordpol- und/oder Südpolkontaktabschnittes. Die Einfassung kann vorzugsweise an gegenüberliegenden Seiten des Nordpol- bzw. Südpolkontaktabschnitts oder weiter bevorzugt vollumfänglich erfolgen. Das Gleitkontaktelement kann damit auf einfache Art und Weise an dem Magnetelement angeordnet werden.

Nach einer bevorzugten Ausführungsform mit den Merkmalen des Patentanspruchs 8 wird eine weitere alternative Ausgestaltung des Gleitkontaktelementes vorgeschlagen. Das Gleitkontaktelement ist vorzugsweise zwischen dem Spulenkern und dem Magnetelement derart angeordnet, dass der Spulenkern wenigstens mit den Polkontaktabschnitten und das Magnetelement wenigstens mit dem Nordpolkontaktabschnitt und dem Südpolkontaktabschnitt das Gleitkontaktelement auf zugeordneten Oberflächenseiten des Gleitkontaktelementes kontaktieren können. Die Oberflächenseiten bilden dabei eine Anlagefläche für die stationäre Komponente und eine Gleitkontaktfläche für die bewegbare Komponente aus. Mit anderen Worten formt die Oberflächenseite eine Anlagefläche aus, wenn der Spulenkern oder das Magnetelement in Anlage mit dieser Oberflächenseite die nichtbewegbare, also stationäre Komponente während der Relativbewegung abbildet. Dahingegen bildet die Oberflächenseite die Gleitkontaktfläche für die während der Relativbewegung bewegte Komponente aus. Mit einem solch ausgeformten Gleitkontaktelement kann vorzugsweise über einen gesamten Bewegungsweg der Relativbewegung eine gleitende Führung der bewegbaren Komponente unter Beibehaltung des magnetischen Kontakts erreicht werden. Die gleitende Führung wird dadurch weiter verbessert. Zwar bedingt die gleitende Führung generell Reibungskräfte, die es während der Relativbewegung durch eine entsprechend erhöhte Betätigungskraft zu überwinden gilt. Jedoch sind die Reibungskräfte verlustärmer als die durch Prellen erzeugten Energieertragsverluste. Trotz der Reibungskräfte ist die Betätigungskraft auf den bevorzugten vorbeschriebenen Betrag reduzierbar. Zur Kompensierung bzw. Verringerung der Reibungskräfte kann die Gleitkontaktfläche vorzugsweise oberflächenbehandelt werden. Vorzugsweise können diverse Gleitmodifikatoren wie Fette, Öle, Beschichtungen oder ähnlichem verwendet werden, um eine mit Blick auf Reibungsverluste verbesserte Gleitkontaktfläche bereitzustellen. Alternativ oder zusätzlich kann die Gleitkontaktfläche vorzugsweise poliert werden.

Weiter bevorzugt ist das Gleitkontaktelement an dem Magnetelement, welches weiterhin bevorzugt die bewegbare Komponente abbildet, angeordnet. Zwar wird dadurch ein ständiger magnetischer Nebenfluss zwischen dem Nordpolkontaktabschnitt und dem Südpolkontaktabschnitt über das Gleitkontaktelement erzeugt. Der Betrag des Nebenflusses ist jedoch relativ gering und beeinträchtigt den zwischen dem Spulenkern und dem Magnetelement in der Ruhestellung erzeugten Hauptfluss kaum nennenswert. Der geringe Einfluss kann vorzugsweise weiter dadurch verringert werden, dass das Gleitkontaktelement aus einem Feinblech oder einer Folie ausgebildet ist. Das aus Feinblech hergestellte Gleitkontaktelement weist vorzugsweise eine maximale Dicke von weniger als 3 mm auf, da die Dicke und damit der Querschnitt des Gleitkontaktelementes einen erheblichen Einfluss auf den magnetischen Nebenfluss hat. Weiter bevorzugt wird eine magnetisierbare Folie mit einer Dicke von 0,05 mm bis 0,1 mm verwendet. Je nach Anwendung und Größe des Induktionsgenerators können unter Berücksichtigung des Querschnitteinflusses auch dickere Folien bzw. Feinbleche als Gleitkontaktelement verwendet werden. Aufgrund des mit der bevorzugten geringen Dicke einhergehenden geringen Querschnitts des Gleitkontaktelements kann der Betrag des Nebenflusses optimal verringert bzw. vorbestimmbar reguliert werden. Grundsätzlich gilt, dass der Betrag des Nebenflusses mit abnehmendem Querschnitt des Gleitkontaktelementes verringerbar bzw. minimierbar ist. Auf Basis des geringen Querschnitts ist das Gleitkontaktelement bereits bei einem schwachen magnetischen Nebenfluss derart gesättigt, dass ab dem Sättigungszeitpunkt das Gleitkontaktelement den Magnetfluss in die Hauptflussrichtung ungehindert durchlässt. Der Sättigungswert kann vorzugsweise zusätzlich oder alternativ durch eine geeignete Materialwahl des Gleitkontaktelementes weiter optimiert werden. In diesem Zusammenhang ist das Gleitkontaktelement weiter bevorzugt aus einem Material ausgeformt, dass die Merkmale des Patentanspruchs 11 erfüllt.

Gemäß einer bevorzugten Ausführungsform mit den Merkmalen nach dem Patentanspruch 10 kann der Querschnitt des Gleitkontaktelements weiter verringert werden. Die wenigstens eine Aussparung wird bevorzugt in einem zwischen dem Nordpolkontaktabschnitt und dem Südpolkontaktabschnitt ausgebildeten Bereich des Gleitkontaktabschnittes angeordnet, womit der Betrag des magnetischen Nebenflusses weiter optimiert werden kann. Die Aussparung weist weiter bevorzugt eine Erstreckung parallel zur Relativbewegungsrichtung auf, die kleiner ist als eine gleichgerichtete Erstreckung des zwischen dem Nordpolkontaktabschnitt und Südpolkontaktabschnitt ausgebildeten Zwischenraumes. Damit kann ein maximal möglicher Magnetfluss (Hauptfluss) zwischen Spulenkern und Magnetelement an der Durchlassfläche bzw. an deren Kontaktfläche gewährleistet werden.

Weiter bevorzugt kann der Effekt des Nebenflusses durch einen stärkeren Permanentmagneten kompensiert werden, der vorzugsweise bis zu 5 % stärker als ein Permanentmagnet ist, der keinem Störeinfluss durch einen magnetischen Nebenfluss unterliegt.

Nach einer weiteren bevorzugten Ausführungsform gemäß einer der Patentansprüche 12 bis 14 kann ein Induktionsgenerator mit einem unabhängig von der Betätigungskraft und Betätigungsgeschwindigkeit zur Ausführung der Relativbewegung vorbestimmt definierbaren Energieertrag und/oder Haptik für den Wechsel zwischen den Ruhestellungen bereitgestellt werden werden. Gemäß dieser Ausführungsform, weiter bevorzugt gemäß einer Ausführungsform nach einem der Patentansprüche 13 und 14 wird ab einer Position, insbesondere ab einer der Zwischenstellung entsprechenden Position, an welcher die Sprungeinrichtung ihre Wirkung entfaltet, eine schlagartig beschleunigte Bewegung der bewegbaren Komponente in Relativbewegungsrichtung ermöglicht.

Ein mit dem Patentanspruch 14 als erste alternative Ausführungsform definierter Induktionsgenerator kann beispielsweise durch ein angefastes Polkontaktabschnittsende realisiert werden, wobei das Ende eine parallel zur Relativbewegungsrichtung verlaufende gleichgroße oder weiter bevorzugt geringere Dicke als ein zwischen dem Nordpolkontaktabschnitt und dem Südpolkontaktabschnitt ausgebildeter gleichgerichteter Abstand aufweist. Alternativ kann das Magnetelement vorzugsweise auch dergestalt sein, dass der Abstand zwischen dem Nordpol- und Südpolkontaktabschnitt gleichgroß oder weiter bevorzugt größer als die Dicke des freien Endes des Polkontaktabschnittes gewählt wird. Damit lässt sich vorzugsweise ab der Zwischenstellung ein sprungartiger Wechsel mit vordefinierter Wechselgeschwindigkeit in die andere Ruhestellung bewirken, welcher abhängig von der Wechselgeschwindigkeit zu einem vorbestimmt definierbaren Energieertrag der Induktionsspule führt. Die Wechselgeschwindigkeit kann vorzugsweise mittels eines Hilfsbetätigers vorbestimmbar definiert werden, wobei der Hilfsbetätiger zwischen dem Betätiger und der bewegbaren Komponente anordbar und mit diesen derart koppelbar ist, dass die auf den Betätiger ausübbare Betätigungskraft auf die bewegbare Komponente übertragbar ist. Der Hilfsbetätiger ist derart ausgebildet, dass die bewegbare Komponente mit einer vordefinierbaren Wechselgeschwindigkeit zur Erzwingung der Relativbewegung nach Betätigen des Betätigers unabhängig von der auf den Betätiger ausgeübten Betätigungsgeschwindigkeit bewegbar ist. Der Hilfsbetätiger umfasst einen Energiespeicher zur Aufnahme und Speicherung einer von dem Betätiger auf den Hilfsbetätiger übertragenden Betätigungsenergie und eine Einrichtung zur Abgabe der gespeicherten Energie als Bewegungsenergie an die bewegbare Komponente mit Verlassen der Position, an welcher die Sprungeinrichtung ihre Wirkung entfaltet. Der Hilfsbetätiger ist vorzugsweise ein Federelement, weiterhin bevorzugt eine Blattfeder oder eine Schraubenfeder. Gemäß diesem bevorzugten Ausführungsbeispiel hat die Betätigungsgeschwindigkeit, mit welcher der Betätiger betätigt wird, keinen Einfluss auf den möglichen Energieertrag der den Spulenkern umgebenden Induktionsspule, da der Umschaltvorgang bzw. die Wechselgeschwindigkeit der bewegbaren Komponente von einer in die andere Ruhestellung hauptsächlich von der Magnetstärke des Permanentmagneten und der Federkonstante des Federelementes abhängt. Damit lässt sich ein Induktionsgenerator mit einem wiederholbar erreichbaren definierten Energieertrag bereitstellen. Des Weiteren kann zusätzlich oder alternativ eine den Wechsel anzeigende Haptik bereitgestellt werden. Denn in der Position, in welcher die Sprungeinrichtung ihre Wirkung entfaltet, ist der Wechsel durch die schlagartig beschleunigte Bewegung der bewegbaren Komponente wenigstens deutlich spürbar. Abhängig von dem definierten Verhältnis in Verbindung mit der Federkonstante ist der Haptikeffekt vorbestimmt definier- und regulierbar.

Mit der mit dem Patentanspruch 14 weiteren bevorzugten alternativen Ausführungsform können die gleichen Effekte erzielt werden. Die Erhebung kann vorzugsweise durch Verformen des Gleitkontaktelementes, durch stoffschlüssiges Aufbringen oder durch Formschluss eines vorbestimmt ausgestalteten Erhebungselements mit dem Gleitkontaktelement an einer gewünschten Position des Induktionsgenerators, vorzugsweise in einer der Zwischenstellüng entsprechenden Position ausgebildet werden. Die Erhebung kann in seiner Querschnittsform variieren und dem vorbestimmt zu erreichenden Energieertrag entsprechend ausgebildet sein. Die Erhebung kann vorzugsweise eine in Bewegungsrichtung führende Rampe für die bewegbare Komponente umfassen, um das sprungartige Umschalten bzw. Wechseln zwischen den Ruhestellungen, vorzugsweise von der Zwischenstellung in die in Relativbewegungsrichtung angeordnete Ruhestellung zu begünstigen. Dabei verbleibt der Spulenkern über die vollständige Erstreckung der Erhebung in magnetischen Kontakt mit dem Magnetelement, da der Spulenkern entlang der Erhebung und mittels der vom dem Permanentmagnet ausgehenden Anziehungskraft die Erhebung kontaktierend gleitend führbar ist. Die Form der Erhebung kann vorzugsweise für eine Unterstützung der gleitenden Führung entsprechend angepasst sein. Dazu kann die Erhebung vorzugsweise einen stumpfen Winkel aufweisen. Beispielsweise kann der stumpfe Winkel an einem Übergang zwischen einem sich in Relativbewegungsrichtung erstreckendem Gleitkontaktflächenabschnitt und einem schräg dazu verlaufenden, zu einem Gipfelpunkt der Erhebung führenden Gleitkontaktflächenabschnitt und/oder einem Übergang zwischen einem von dem Gipfelpunkt der Erhebung wegführenden Gleitkontaktflächenabschnitt und einen sich in Relativbewegungsrichtung erstreckenden Gleitkontaktflächenabschnitt vorgesehen sein. Alternativ oder zusätzlich kann der Gipfelpunkt der Erhebung vorzugsweise mit einem stumpfen Winkel auf der der Gleitkontaktfläche gegenüberliegende Seite ausgebildet sein.

Wie in Verbindung mit der ersten Alternative beschrieben, lässt sich für die zweite Alternative gleichfalls der zu erzeugende gleich bleibende Energieertrag wiederholbar erreichen, indem vorzugsweise ein wie vorbeschriebener Hilfsbetätiger in Verbindung mit der bewegbaren Komponente verwendet wird. Auch kann die Haptik mittels der Erhebung reguliert werden. Dabei kann bei diesem Ausführungsbeispiel durch Austauschbarkeit des Gleitkontaktelementes mit einem anderen Gleitkontaktelement, das eine andersartig ausgestaltete Erhebung aufweist, auf einfache Art und Weise ein Induktionsgenerator mit anpassbarer Haptik bzw. vordefinierbaren Energieertrag bereitgestellt werden.

Gemäß einem weiteren Aspekt der vorliegenden Erfindung wird ein Funkschalter mit einer Senderbaugruppe und einer Antenne gemäß dem Patentanspruch 15 vorgeschlagen. Der Funkschalter ist in der Lage, die mittels des Induktionsgenerators erzeugte Induktionsspannung für eine Übertragung eines Funksignals über die Senderbaugruppe und die Antenne zu verwenden. Weiter bevorzugt weist der Funkschalter einen wie vorbeschriebenen, mit der bewegbaren Komponente zur Erzwingung der Relativbewegung gekoppelten Hilfsbetätiger auf. Der Hilfsbetätiger kann vorzugsweise ein bistabiles oder ein monostabiles Federelement sein. Unter einem bistabilen Federelement ist ein Federelement zu verstehen, mittels welchem die bewegbare Komponente mit einer Betätigung in eine der Ruhestellungen und mit einer weiteren Betätigung in die andere der Ruhestellungen wiederholbar bewegbar ist. Wohingegen ein monostabiles Federelement ein Federelement ist, mittels welchem die bewegbare Komponente mit einer Betätigung in die eine Ruhestellung bewegbar und anschließend in die andere Ruhestellung automatisch rückstellbar ist. Das monostabile Federelement kann vorzugsweise ein einziges Federelement sein, welches ein entgegen der Betätigungskraft gerichtete Rückstellkraft ausübendes Federelement integral mit ausbildet oder aus wenigstens zwei Federelementen bestehen, die jeweils in Richtung einer Ruhestellung und zueinander entgegengesetzt federelastisch wirken.

Weitere Merkmale und Vorteile der Erfindung, die durch die Patentansprüche definiert ist, ergeben sich aus der nachfolgenden Beschreibung von Ausführungsbeispielen der Erfindung und anhand der Figuren der Zeichnungen, die erfindungswesentliche Einzelheiten zeigen.

Bevorzugte Ausführungsformen der Erfindung werden nachfolgend anhand der beigefügten Zeichnungen näher erläutert. Es zeigen:
- Fig. 1A: eine schematische Seitenansicht eines Induktionsgenerators gemäß einer bevorzugten Ausführungsform in einer einer ersten Ruhestellung entsprechenden Position;
- Fig. 1B: eine schematische Seitenansicht des in Fig. 1A gezeigten Induktions-generators in einer einer Zwischenstellung entsprechenden Position;
- Fig. 1C: eine schematische Seitenansicht des in Fig. 1A und 1B gezeigten Induktionsgenerators in einer einer zweiten Ruhestellung entsprechenden Position;
- Fig. 2A: eine schematische Seitenansicht eines Induktionsgenerators gemäß einer bevorzugten Ausführungsform in der einer Zwischenstellung entsprechenden Position;
- Fig. 2B: eine schematische Darstellung des in Fig. 2A gezeigten Induktionsgenerators;
- Fig. 3: eine schematische Seitenansicht eines Induktionsgenerators gemäß einer bevorzugten Ausführungsform in der einer zweiten Ruhestellung entsprechenden Position;
- Fig. 4: eine schematische Seitenansicht eines Induktionsgenerators gemäß einer bevorzugten Ausführungsform in der einer Zwischenstellung entsprechenden Position; und
- Fig. 5: eine perspektivische Seitenansicht eines Induktionsgenerators gemäß einer bevorzugten Ausführungsform in der einer zweiten Ruhestellung entsprechenden Position.

In der nachfolgenden Beschreibung und den Zeichnungen entsprechen gleiche Bezugszeichen Elemente gleicher oder vergleichbarer Funktion.

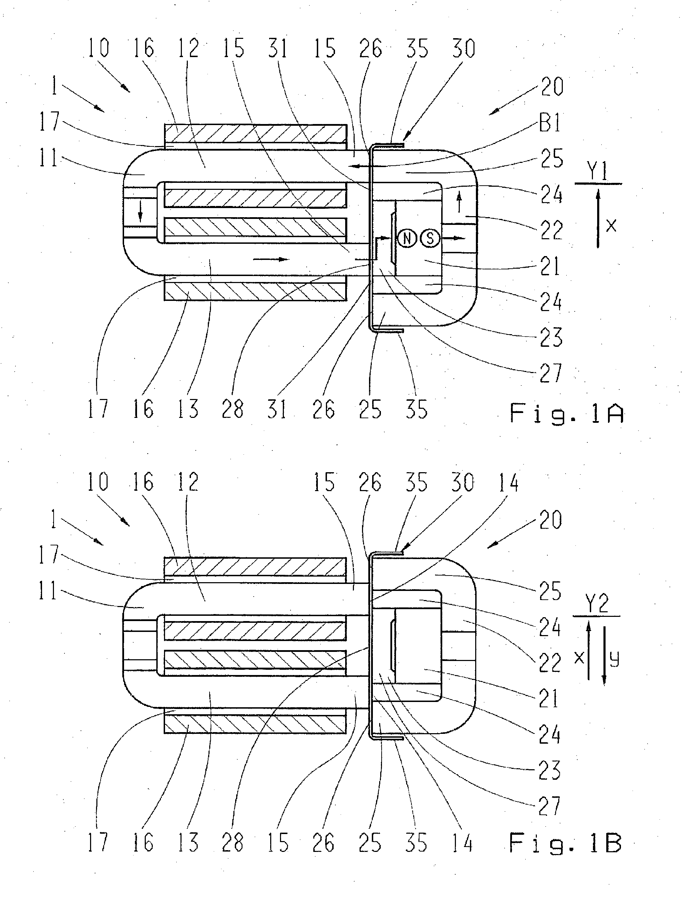

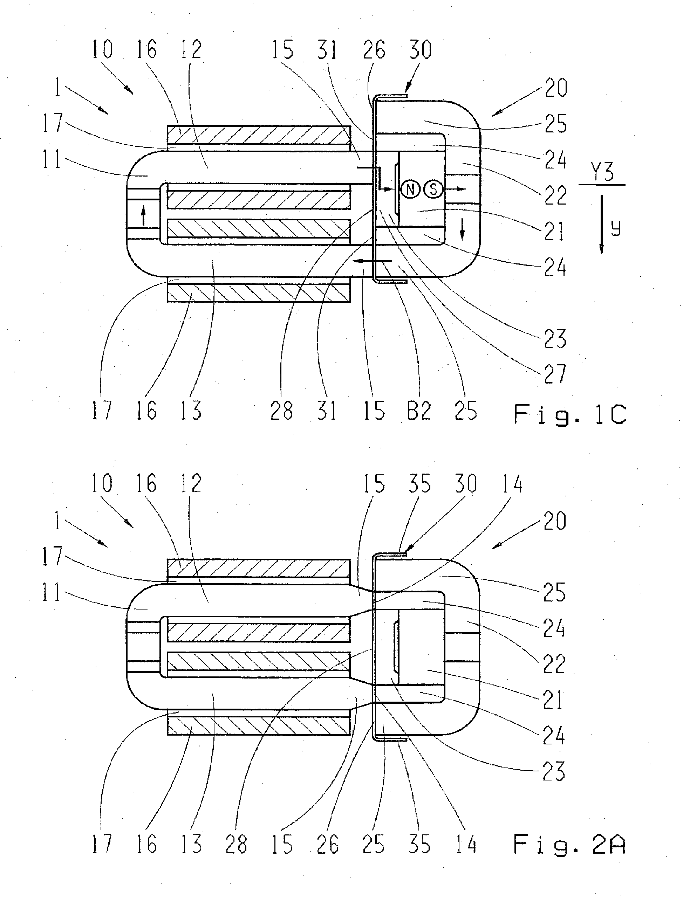

Fig. 1A bis 1C zeigen eine Seitenansicht eines Induktionsgenerators 1 gemäß einer bevorzugten Ausführungsform der vorliegenden Erfindung, wobei Fig. 1A den Induktionsgenerator 1 in einer einer ersten Ruhestellung Y1 entsprechenden Position, Fig. 1 B den Induktionsgenerator 1 in einer einer Zwischenstellung Y2 definierenden Position und Fig. 1C den Induktionsgenerator 1 in einer einer zweiten Ruhestellung Y3 entsprechenden Position zeigen. Der Induktionsgenerator 1 dieser Ausführungsform umfasst im Wesentlichen drei Komponenten, nämlich eine eine Induktionsspannung erzeugende erste Komponente 10, eine einen Magnetfluss erzeugende zweite Komponente 20, wobei die erste 10 und zweite Komponente 20 relativ zueinander zwischen der ersten Ruhestellung Y1 und der zweiten Ruhestellung Y3 bewegbar angeordnet sind, und eine die Relativbewegung zwischen der ersten 10 und zweiten Komponente 20 gleitend führende dritte Komponente 30. Die Relativbewegung von der ersten Ruhestellung Y1 über die Zwischenstellung Y2 zur zweiten Ruhestellung Y3 ist in den Fig. 1B und 1C mit Y und die zurückgehende Relativbewegung von der zweiten Ruhestellung Y3 über die Zwischenstellung Y2 zu der ersten Ruhestellung Y1 ist in den Fig. 1A und 1B mit X dargestellt.

Die erste Komponente 10 des Induktionsgenerators 1 umfasst zwei Induktionsspulen 16, die jeweils einen Durchgang 17 aufweisen, wobei die Durchgänge 17 bzw. die Induktionsspulen 16 parallel zueinander angeordnet sind. Es können so zwei gleichartig ausgebildete Induktionsspulen für den Induktionsgenerator 1 verwendet werden, wodurch sich Herstellungskosten weiter reduzieren lassen. Die erste Komponente 10 weist ferner einen U-förmigen Spulenkern 11 aus einem magnetisierbaren Material auf. Die Schenkel 12, 13 des U-förmigen Spulenkerns 11 ragen durch jeweils einen Durchgang 17 derart hindurch, dass die jeweils einen Polkontaktabschnitt ausformenden freien Schenkelenden 15 mit ihren jeweiligen eine Polkontaktfläche ausbildende Stirnflächen 14 von einem stirnseitigen Ende der entsprechenden Induktionsspule 16 abragen, wobei die Polkontaktfläche 14 in eine einem Grund der U-Form abgewandte Richtung zeigt. Vorzugsweise sind die Schenkel 12, 13 zentriert durch den jeweiligen Durchgang 17 hindurchgeführt, um in jeder Induktionsspule 16 eine gleichartige Induktionsspannung bei einer Spulenumkehrpolung erzeugen zu können.

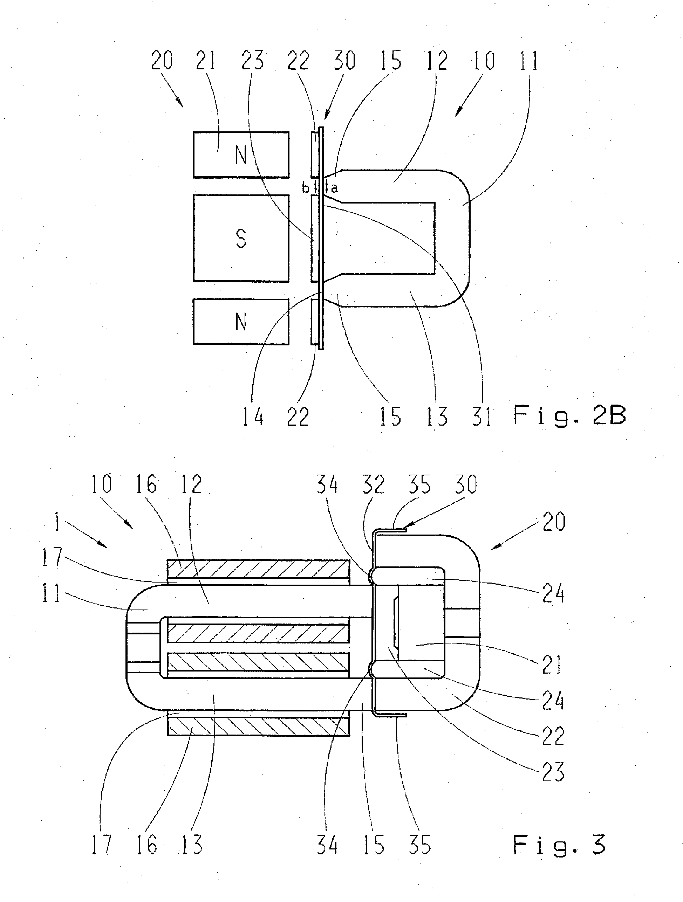

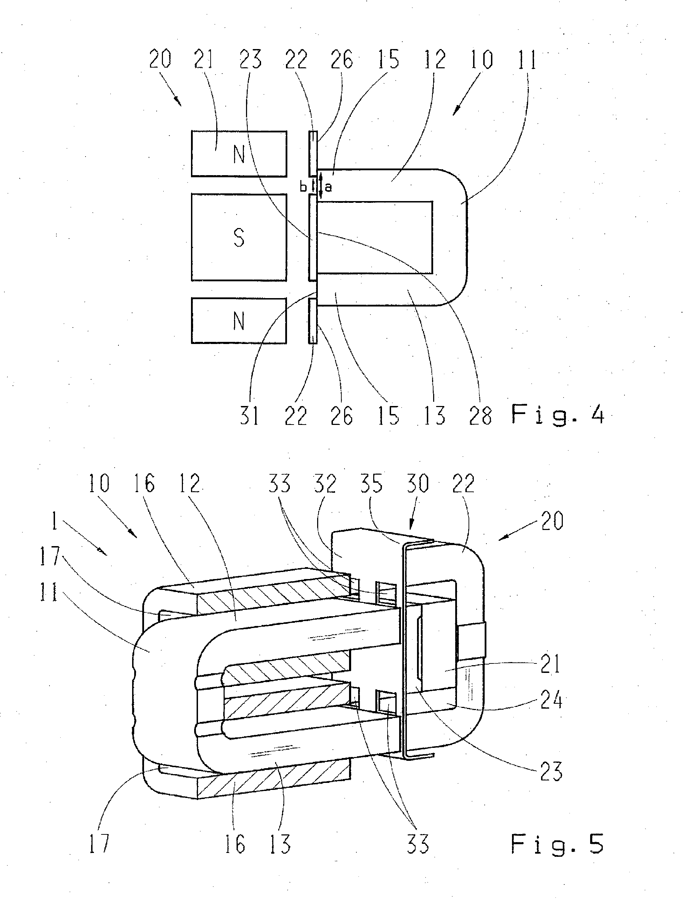

Die zweite Komponente 20 ist der ersten Komponente 10 gegenüberliegend angeordnet. Die zweite Komponente 20 wird durch ein Magnetelement 20 ausgeformt, welches dem Spulenkern 11 und den Induktionsspulen 16 gegenüberliegend angeordnet ist. Das Magnetelement 20 umfasst einen Permanentmagneten 21, der von zwei Polschuhen 22, 23 eingefasst ist. Der erste Polschuh 22 ist U-förmig ausgebildet und liegt an einem Südpol S des Permanentmagneten 21 derart an, dass das jeweilige, eine eine Südpolkontaktfläche definierende erste Polschuhfläche 26 aufweisende freie Schenkelende 25 des ersten Polschuhs 22 die dem Spulenkern 11 zugewandte Fläche des Nordpols N des Permanentmagneten 21 überragt, wobei die jeweiligen Südpolkontaktflächen 26 des ersten Polschuhs 22 dem Spulenkern 11 zugewandt sind. An der Nordpolseite N des Permanentmagneten 21 ist ein dem Ausmaß der dem Spulenkern 11 zugewandten Nordpolfläche des Permanentmagneten 20 entsprechender zweiter Polschuh 23 angeordnet. Der zweite Polschuh 23 weist eine in Richtung des Spulenkerns 11 verlaufende solche Dicke auf, dass eine dem Spulenkern 11 zugewandte, eine Nordpolkontaktfläche definierende zweite Polschuhfläche 28 des zweiten Polschuhs 23 in einer gemeinsamen Ebene mit den Südpolkontaktflächen 26 liegt. Der erste 22 und zweite Polschuh 23 bestehen aus einem magnetisierbaren Material. Der erste 22 und zweite Polschuh 23 können aus demselben Material wie der Spulenkern 11 gefertigt sein. Des Weiteren kann der erste Polschuh 22 alternativ an dem Nordpol N des Permanentmagneten 20 und der zweite Polschuh 23 an dem Südpol S anliegen (Fig. 2B und Fig. 4). Wesentlich für diese Ausführungsform ist, dass die ersten Polschuhflächen 26 und die zweite Polschuhfläche 28 den Polkontaktflächen 14 des Spulenkerns 11 zugewandt und in einer die Schenkel 12, 13 verbindenden Richtung alternierend angeordnet sind, wobei die ersten Polschuhflächen 26 in dieser Richtung die zweite Polschuhfläche 28 einfassen. Die ersten Polschuhflächen 26 bilden in dieser Anordnung äußere Polschuhflächen aus, während die zweite Polschuhfläche 28 eine mittige Polschuhfläche abbildet.

Die Südpolkontaktflächen 26 und die Nordpolkontaktfläche 28 sind voneinander derart beabstandet, dass eine der Südpolkontaktflächen 26 in der ersten Ruhestellung Y1 einer der Polkontaktflächen 14 unmittelbar gegenüberliegend zugewandt ist, und die Nordpolkontaktfläche 28 in der ersten Ruhestellung Y1 einer anderen der Polkontaktflächen 14 gegenüberliegend zugewandt ist, wie in Fig. 1A im Besonderen gezeigt. Hier liegt die in der Fig. 1A gezeigte obere Südpolkontaktfläche 26 der Polkontaktfläche 14 des Polkontaktabschnitts 15 des oberen Schenkels 12 und die Nordpolkontaktfläche 28 der Polkontaktfläche 14 des Polkontaktabschnitts 15 des unteren Schenkels 13 unmittelbar gegenüber. Die Polkontaktabschnitte 15 des Spulenkerns 11 und die Südpolkontaktabschnitte 25 des ersten Polschuhs 22 weisen in dieser Ausführungsform ein gleichartiges Ausmaß zumindest an ihren unmittelbar gegenüberliegenden Flächen 14, 26 auf. Ferner ist der Abstand zwischen dem jeweiligen ersten 22 und dem zweiten Polschuh 23 so gewählt, dass in der zweiten Ruhestellung Y3 die andere Südpolkontaktfläche 26 der anderen der Polkontaktflächen 14 und die Nordpolkontaktfläche 28 der einen der Polkontaktflächen 14 unmittelbar gegenüberliegend zugewandt ist, wie in Fig. 1C gezeigt. Hier liegt die Nordpolkontaktfläche 28 der Polkontaktfläche 14 des Polkontaktabschnitts 15 des oberen Schenkels 12 und die untere Südpolkontaktfläche 26 der Polkontaktfläche 14 des Polkontaktabschnitts 15 des unteren Schenkels 13 unmittelbar gegenüber.

Die dritte Komponente 30 wird durch ein aus einem magnetisierbaren Material hergestelltes Gleitkontaktelement 30 ausgebildet, welches zwischen den Polkontaktflächen 14 und den Polschuhflächen 26, 28 angeordnet ist. Das Gleitkontaktelement 30 hat eine Dicke in einem bevorzugten Bereich von 0,05 mm bis 0,1 mm. Das Gleitkontaktelement 30 erstreckt sich in Anordnungsrichtung der Polschuhflächen 26, 28 über die gesamte Ausdehnung der zweiten Komponente 20. In einer zu dieser Anordnungsrichtung Querverlaufende und eine Breite des Induktionsgenerators 1 definierende Richtung überdeckt das Gleitkontaktelement 30 wenigstens 100 % der jeweiligen Polkontaktfläche 14 sowie der jeweiligen Polschuhflächen 26, 28.

Wie in Fig. 1A bis 1C ferner dargestellt, ist das Gleitkontaktelement 30 querschnittlich U-förmig ausgeformt und an dem Magnetelement 20 derart angeordnet, dass die Schenkel 35 des Gleitkontaktelements 30 an dem Magnetelement 20 anliegen. Vorzugsweise liegen die Schenkel 35 unter einer Vorspannkraft an dem Magnetelement 20 an, um das Gleitkontaktelement 30 nicht nur über die zwischen Gleitkontaktelement 30 und dem Magnetelement 20 vorliegende Magnetkraft in eine der Polschuhflächen 26, 28 abgewandte Richtung, sondern zusätzlich über die von den Schenkeln 35 auf das Magnetelement 20 ausgeübte Vorspannkraft in eine parallel zur Relativbewegung verlaufende Richtung an dem Magnetelement 20 zu halten. Des Weiteren kann in einer bevorzugten, nicht dargestellten Ausführungsform das Gleitkontaktelement 30 über weitere Fixierelemente verfügen, die an gegenüberliegenden Seiten wenigstens eines der Polschuhe 22, 23 zur Anlage kommen können, um das Gleitkontaktelement 30 zusätzlich in einer Breitenrichtung des Induktionsgenerators 1 an dem Magnetelement 20 zu halten. Die Länge der Schenkel 35 sowie vorzugsweise der weiteren Fixierelemente kann so gewählt sein, dass eine zur Befestigung des Gleitkontaktelements 30 an dem Magnetelement 20 ausreichende Halte- bzw. Vorspannkraft erzeugbar ist. Aufgrund der Tatsache, dass das Gleitkontaktelement 30 aus einem Blechstreifen oder einer Folie hergestellt ist, kann die Vorspannkraft auf einfache Weise durch ein entsprechendes zueinander gerichtetes Biegen der Schenkel 35 bzw. der Fixierelemente erzielt werden.

Das Gleitkontaktelement 30 bildet auf seine dem Spulenkern 11 und dem Magnetelement 20 zugewandten Oberflächenseiten Anlageflächen bzw. Gleitkontaktflächen 32 für den Spulenkern 11 bzw. dem Magnetelement 20 aus. Die Anlage- bzw. Gleitkontaktfläche 32 ist eben ausgeformt und kontaktiert die Polkontaktflächen 14 des Spulenkerns 11 sowie die Polschuhflächen 26, 28 der Polschuhe 22, 23 jeweils flächig. Da in dieser Ausführungsform das Gleitkontaktelement 30 stationär an dem Magnetelement 20 angeordnet ist, formt die dem Magnetelement 20 zugewandte Oberflächenseite eine Ablagefläche für das Magnetelement 20 aus, während die dem Spulenkern 11 zugewandte Oberflächenseite des Gleitkontaktelements 30 die Gleitkontaktfläche 32 für den Spulenkern 11 ausbildet. Es sind aber auch Ausführungsformen vorstellbar, bei welchen das Gleitkontaktelement 30 zwei Gleitkontaktflächen 32 bereitstellt, eine für das Magnetelement 20 und eine für den Spulenkern 11, wobei das Gleitkontaktelement 30 beispielsweise durch ein den Induktionsgenerator 1 beherbergendes Gehäuse gehalten werden kann.

Wie mit den Fig. 1A bis 1C dargestellt, wird bei einem Wechsel zwischen der ersten Y1 und zweiten Ruhestellung Y3 die erste Komponente 10 entlang der Gleitkontaktfläche 32 gleitend geführt. Damit werden das Magnetelement 20 und der Spulenkern 11 voneinander in einer Richtung quer zu einer zwischen diesen Komponenten 10 ,20 wirkenden Anziehungskraft getrennt. Die Betätigungskraft zum Erzwingen der Relativbewegung kann somit in einem erheblichen Maß reduziert werden. Vorzugsweise wird für die gleitende Relativbewegung lediglich eine Betätigungskraft von max. 30 % der Anziehungskraft zwischen Magnetelement 20 und Spulenkern 11 und weiter bevorzugt in einem Bereich von 20 % bis 30 % benötigt.

Ferner kann zur Verringerung von Gleitreibungskräften die Gleitkontaktfläche 32 behandelt sein. So kann die Gleitkontaktfläche 32 beispielsweise poliert sein und/oder mit Gleitmodifikatoren wie Fette, Beschichtungen und ähnlichem behandelt sein. Die zur Durchführung der Relativbewegung, also nach dem Beginn der Relativbewegung zum weiteren Fortführen der Relativbewegung zwischen der ersten 10 und zweiten Komponente 20 notwendige Betätigungskraft kann dadurch verringert werden, wodurch sich die Relativbewegung insgesamt leichter ausführen lässt. Im Übrigen muss nicht zwangsläufig die vollständige Oberfläche des Gleitkontaktelements 30 für eine Verringerung der Reibungskräfte behandelt sein, sondern lediglich ein den Bewegungsweg des Spulenkerns 11 entsprechender Gleitkontaktflächenabschnitt 31, welcher die Gleitkontaktfläche 32 umfasst und über welchen die gleitende Führung des Spulenkerns 11 erfolgt.

Im Folgenden wird auf das Zusammenwirken der ersten 10, zweiten 20 und dritten Komponente 30 eingegangen.

Wie in den Fig. 1A bis 1C gezeigt, verbindet das Gleitkontaktelement 30 die Südpolkontaktflächen 26 mit der Nordpolkontaktfläche 28, wodurch es zu einem ständigen magnetischen Nebenfluss zwischen diesen Flächen 26, 28 kommt. In der jeweiligen Ruhestellung Y1 und Y3 beeinträchtigt zwar der Nebenfluss den zwischen Magnetelement 20 und Spulenkern 11 erzeugbaren magnetischen Hauptfluss B1, B2. Die Stärke des Nebenflusses ist jedoch abhängig von dem Querschnitt des Gleitkontaktelementes 30 und kann mittels Querschnittsvariation entsprechend beeinflusst werden. Prinzipiell gilt, dass je geringer der Querschnitt des Gleitkontaktelementes 30 ist, desto weniger wird der Hauptfluss B1, B2 durch den Nebenfluss beeinträchtigt. Denn ein geringer Querschnitt führt zu einer schnelleren Sättigungsmagnetisierung des Gleitkontaktelements 30 derart, dass der zwischen Spulenkern 11 und Magnetelement 20 erzeugbare Hauptfluss B1, B2 nach Erreichen der Sättigungsmagnetisierung durch den magnetischen Nebenfluss nicht weiter beeinträchtigt wird. Mit anderen Worten wird der magnetische Hauptfluss B1, B2 in seinem Betrag maximal durch den Betrag des die Sättigungsmagnetisierung ausmachenden magnetischen Nebenflusses reduziert. Die Sättigungsmagnetisierung korrespondiert zu einer Magnetisierung, bei welcher das Gleitkontaktelement 30 trotz Erhöhung einer auf das Gleitkontaktelement 30 einwirkenden magnetischen Feldstärke durch den Permanentmagneten keine Erhöhung in der Magnetisierung erfährt. Der über den Nebenfluss zwangsläufig abgezweigte Betrag kann vorzugsweise über einen stärkeren Permanentmagneten kompensiert werden. Für das in dieser bevorzugten Ausführungsform verwendete Gleitkontaktelement 30 mit einer Dicke von 0,05 mm bis 0,1 mm reicht ein bis zu 5 % stärkerer Permanentmagnet aus.

Weiter bevorzugt kann das Gleitkontaktelement 30 aus einem Material ausgebildet sein, das eine größere magnetische Leitfähigkeit als das Material der Polschuhe 22, 23 und des Spulenkerns 11 hat. Der Querschnitt des Gleitkontaktelements 30 kann darüber hinaus durch in dem Gleitkontaktelement 30 ausgeformte Aussparungen 33 verringert werden (Fig. 5). Wie in Fig. 5 dargestellt, sind die Aussparungen 33 in einem Bereich angeordnet, der einem zwischen den Polschuhen 22, 23 ausgebildeten Zwischenraum 24 gegenüberliegt. Die Aussparungen 33 weisen entlang des durch die Bewegungsrichtung X; Y definierenden Bewegungsweges ein Ausmaß auf, das gleich oder kleiner als ein gleichgerichteter Ausmaß des Zwischenraumes 24 bzw. der Abstand zwischen dem Südpolkontaktabschnitt 25 und dem Nordpolkontaktabschnitt 27 in der Bewegungsrichtung X; Y ist.

Wie in Fig. 1A und 1C ferner gezeigt, wird in der ersten Y1 und zweiten Ruhestellung Y2 mittels Kontakt der Polschuhflächen 26, 28 und der Polkontaktfläche 14 mit dem Gleitkontaktelement 30 ein einen ersten B1 bzw. einen zweiten Magnetfluss B2 definierender magnetischer Hauptfluss B1, B2 erzeugt, der ringförmig über den Spulenkern 11 und dem Magnetelement 20 verläuft. Das Magnetelement 20 und der Spulenkern 11 werden in dieser Position durch die magnetische Anziehungskraft bedingte Haltekraft gehalten. Durch eine quer zu der Haltekraft verlaufende, auf das Magnetelement 20 oder den Spulenkern 11 wirkende Betätigungskraft kommt es zu der Relativbewegung zwischen dem Magnetelement 20 und dem Spulenkern 11 in X- bzw. Y-Bewegungsrichtung. Der Spulenkern 11 wird gleitend entlang der Gleitkontaktfläche 32 in Richtung der Zwischenstellung Y2 geführt. Mit zunehmender Entfernung zu dem Südpolkontaktabschnitt 25 verringert sich die auf den Spulenkern 11 wirkende magnetische Anziehungskraft des Magnetelements 20, welche in der Zwischenstellung Y2 einen niedrigsten Wert erreicht. Aufgrund des durch den Permanentmagneten 21 ständig magnetisierten Gleitkontaktelements 30 übt dieses eine ständige Anziehungskraft auf den Spulenkern 11 aus, wodurch eine magnetisch bedingte kontinuierliche Anhaftung des Spulenkerns 11 an dem Gleitkontaktelement 30 bzw. ein magnetischer Kontakt zwischen diesen Komponenten über den vollständigen Bewegungsweg zwischen der ersten Y1 und zweiten Ruhestellung Y3 gewährleistet wird. Sobald der Spulenkern 11 während der Relativbewegung die Zwischenstellung Y2 in Richtung der ersten Y1 bzw. zweiten Ruhestellung Y3 verlässt, nimmt die Anziehungskraft des Magnetelements 20 zu, wodurch die Relativbewegung zwischen dem Spulenkern 11 und dem Magnetelement 20 eine Beschleunigung erfährt, bis der Spulenkern 11 die erste Y1 bzw. zweite Ruhestellung Y3 erreicht hat. Nach Erreichen der ersten Y1 bzw. zweiten Ruhestellung Y3 (Fig. 1A bzw. Fig. 1 C) wird ein entsprechender Magnetfluss B1, B2 erzeugt, der ringförmig entgegensetzt zu der anfänglichen Magnetflussrichtung verläuft. Dadurch kommt es zu einer eine Induktionsspannung erzeugenden Spulenumkehrpolung, wobei die erzeugte Spannung vorzugsweise mittels einer an den Induktionsgenerator 1 anschließbaren Sendebaugruppe beispielsweise in einem Funkschalter für ein Übertragungssignal verwendet werden kann.

Die bewegte Komponente in dieser beispielhaft beschriebenen Ausführungsform kann der Spulenkern 11 oder das Magnetelement 20 sein. Es ist auch vorstellbar, dass der Spulenkern 11 und das Magnetelement 20 in einem den Induktionsgenerator 1 aufnehmenden Gehäuse beispielsweise eines Funkschalters bewegbar gehalten werden. Bevorzugt wird das Magnetelement 20 mit dem daran angeordneten Gleitkontaktelement 30 bewegbar vorgesehen. Dadurch können die im beweglichen Bereich wirkenden Kräfte gering gehalten werden. Die erste Komponente 10 mit den Induktionsspulen 16 und dem Spulenkern 11 wird dabei vorzugsweise stationär bzw. ortsfest in dem aufnehmenden Gehäuse gehalten. Die einzelnen Komponenten 10, 20, 30 des Induktionsgenerators 1 sowie das den Induktionsgenerator 1 aufnehmende bzw. haltende Gehäuse sind aufeinander in üblicher Weise derart abzustimmen, dass die gewünschte Funktionalität wie ortsfest Halten und entsprechend bewegbares Vorsehen der ersten 10, zweiten 20 oder dritten Komponente 30 zwischen der ersten Y1 und zweiten Ruhestellung Y3 zur Erzeugung einer Induktionsspannung erzielbar ist.

Das vorbeschriebene Umschalten zwischen den Ruhestellungen Y1, Y3 kann unmittelbar oder vorzugsweise durch ein oder mehrere Federelemente bewirkt werden, die mit dem Induktionsgenerator 1 in einem Gehäuse beispielsweise eines Funkschalters gehalten werden, wobei die Federelemente derart angeordnet und ausgebildet sind, dass eine auf ein Betätigungselement des Funkschalters ausgeübte Betätigungskraft auf die zu bewegende Komponente federelastisch übertragbar ist, um eine sprungartige Bewegung der zu bewegenden Komponente zwischen den Ruhestellungen Y1, Y3 erzwingen zu können. Dazu weist die erste 10 und/oder zweite Komponente 20 vorzugsweise Angriffspunkte für das oder die Federelement(e) für eine federelastische Übertragung der zum Umschalten benötigten Betätigungskraft auf die zu bewegende Komponente auf.

Fig. 2A bis 3 zeigen bevorzugte Ausführungsformen eines Induktionsgenerators 1 nach der vorliegenden Erfindung mit unterschiedlicher Sprungeinrichtung. Im Einzelnen zeigen Fig. 2A und 2B eine schematische Seitenansicht eines Induktionsgenerators 1 mit einem ersten Sprungeinrichtungstyp in einer der Zwischenstellung Y2 entsprechenden Position, wobei Fig. 2B eine konzeptionelle Darstellung des mit Fig. 2A gezeigten Induktionsgenerators 1 ist. Fig. 3 zeigt eine schematische Seitenansicht eines Induktionsgenerators 1 mit einem zweiten Sprungeinrichtungstyp.

Der in den Fig. 2A und 2B gezeigte Induktionsgenerator 1 unterscheidet sich von dem in Fig. 1A bis 1C gezeigten Induktionsgenerator 1 im Wesentlichen durch die besondere Ausgestaltung der Polkontaktabschnitte 15 sowie durch die um 180° gedrehte Anordnung des Permanentmagneten 21, der mit dem Nordpol den U-förmigen Polschuh 22 kontaktiert. Die Polkontaktabschnitte 15 verjüngen sich in Richtung der Polkontaktfläche 14 auf ein Maß a, das gleich oder geringer als ein zwischen der Nordpolkontaktfläche 26 und der Südpolkontaktfläche 28 ausgeformter Abstand b ist. Bei einem Wechsel zwischen der ersten Y1 und zweiten Ruhestellung Y3 wird der Spulenkern 11 von den jeweiligen Polschuhen 22, 23 derart angezogen, dass nach Verlassen der Zwischenstellung Y2 ein sprungartiger Wechsel in die jeweilige erste Y1 bzw. zweite Ruhestellung Y3 erfolgt. Der sich verjüngende Polkontaktabschnitt 15 und der Zwischenraum 24 bilden somit die Sprungeinrichtung aus. Der Induktionsgenerator 1 kann bei diesem Ausführungsbeispiel mit unterschiedlicher Betätigungsgeschwindigkeit betätigt werden. Die Betätigungsgeschwindigkeit hat dabei einen direkten Einfluss auf den zu erzeugenden Energieertrag der Induktionsspule 16, da eine Wechselgeschwindigkeit zwischen den Ruhestellungen Y1, Y3 von der Betätigungsgeschwindigkeit abhängt. Des Weiteren ist der Wechsel von der Zwischenstellung Y2 in die jeweilige Ruhestellung Y1, Y3 spürbar, womit die Sprungeinrichtung zudem einen Haptikeffekt bereitstellen kann. In Abhängigkeit des gewählten Verhältnisses von dem Abstand a zu dem Abstand b ist die Haptik einstellbar. Je kleiner das Verhältnis gewählt wird, desto größer ist der damit erzielbare Haptikeffekt.

In Verbindung mit einem vorbeschriebenen, nicht dargestellten Federelement hat eine auf das Federelement ausgeübte Betätigungsgeschwindigkeit dahingegen keinen wirksamen Einfluss auf den durch den Wechsel zwischen den Ruhestellungen Y1, Y3 bedingten Energieertrag, da der Wechsel bzw. die Wechselgeschwindigkeit zwischen den Ruhestellungen Y1, Y3 durch die von dem Federelement sprungartig erzeugte Bewegung beim Verlassen der Zwischenstellung Y2 während eines Überganges des Federelementes von einem belasteten in einen unbelasteten Zustand vorgegeben ist. Die vom Magnetelement 20 ausgehende magnetische Anziehungskraft unterstützt das sprungartige Verhalten begünstigend. Dadurch kann ein definierter Energieertrag von der Induktionsspule 16 wiederholbar erhalten werden, wobei der Energieertrag unabhängig von der auf das Federelement ausgeübten Betätigungsgeschwindigkeit ist.

Auch wenn in diesem Ausführungsbeispiel ein verjüngter Polkontaktabschnitt 15 gezeigt und beschrieben ist, kann der vorbeschriebene Effekt alternativ dadurch erreicht werden, dass statt Verjüngung des Polkontaktabschnitts 15, die Polschuhe 22, 23 mit einem gleichem oder größeren Abstand b mit Blick auf Abstand a angeordnet werden.

Fig. 3 zeigt im Wesentlichen einen wie in den Fig. 1A bis 1C gezeigten Induktionsgenerator 1 mit dem Unterschied, dass das Gleitkontaktelement 30 eine mit dem Gleitkontaktelement 30 integral ausgeformte Erhebung 34 umfasst, die in einem den Zwischenraum 24 überdeckenden Bereich vorgesehen ist. Die Erhebung 34 formt eine Rampe für den Polkontaktabschnitt 15 in Richtung der jeweiligen Ruhestellung Y1; Y3 aus. Die Erhebung 34 ist zu einer durch einen Gipfelpunkt der Erhebung 34 senkrecht verlaufenden Ebene symmetrisch ausgebildet und formt auf jeder Seite des Gipfelpunktes einen mit einem stumpfen Winkel von 135° ausgebildeten Übergang von der Rampe zu einem bis an die Erhebung 34 bzw. an die Rampe heranreichenden flachen Gleitkontaktflächenabschnitt 32 aus. Der stumpfe Winkel liegt weiter bevorzugt in einem Bereich von 135° bis 170°. Die symmetrische Ausgestaltung ist nicht zwangsläufig notwendig. So können die Übergänge mit einem unterschiedlichen Winkel ausgebildet sein, wodurch die Rampen zueinander mit unterschiedlicher Steigung ausgeformt werden können. Der Gipfelpunkt der Erhebung 34 ist flach ausgeformt. Der Gipfelpunkt der Erhebung 34 mit einem auf der Gleitkontaktflächenseite 32 gegenüberliegenden stumpfen Winkel von vorzugsweise gleich oder größer als 135°ausgebildet. Auch kann der Gipfelpunkt in Relativbewegungsrichtung eine zu dem Gleitkontaktflächenabschnitt 32 parallele Erstreckung aufweisen.

Die Erhebung 34 ermöglicht beispielsweise in Verbindung mit einem nicht dargestellten Federelement, wie in dem mit Fig. 2A und 2B vorbeschriebenen Ausführungsbeispiel, einen sprungartigen Wechsel zwischen den Ruhestellungen Y1, Y3 und damit einen wiederholbar erzeugbaren gleichen Energieertrag unabhängig von der auf das Federelement einwirkenden Betätigungskraft und Betätigungsgeschwindigkeit. Nachdem das Federelement durch die Betätigungskraft in den belasteten Zustand versetzt wurde, wird die erste 10 oder zweite Komponente 20 durch den Übergang des Federelementes von dem belasteten in den unbelasteten Zustand in Bewegung gesetzt, wobei der Polkontaktabschnitt 15 während der Relativbewegung durch die ebene Ausgestaltung des bis an die Erhebung 34 heranreichenden Gleitkontaktflächenabschnittes 32 ungehindert bewegbar wird. Mit Beginn des Überganges zu der Erhebung 34 wird die Relativbewegung des Polkontaktabschnittes 15 zunächst abgebremst, um nach Erreichen des Gipfelpunktes der Erhebung 34 schlagartig beschleunigt zu werden. Das magnetisierte Gleitkontaktelement 30 gewährleistet dabei die gleitende Führung des relativ bewegten Polkontaktabschnittes 15 über die Erhebung 34 bzw. den ständigen magnetischen Kontakt des Polkontaktabschnitts 15 mit dem Gleitkontaktelement 30 während der gesamten Relativbewegung.

Der sprungartige Wechsel zwischen den Ruhestellungen Y1, Y3 ist durch die Erhebung 34 ab der Zwischenstellung Y2 wahrnehmbar, wodurch die Erhebung 34 gleichzeitig ein Haptikelement ausbildet. In Abhängigkeit der Ausgestaltung der Erhebung 34 kann die Haptik unterschiedlich wahrnehmbar eingestellt bzw. der vorbestimmt definierbare Energieertrag reguliert werden.

Die mit den Fig. 2A bis 3 gezeigten Ausführungsbeispiele sind vorteilhaft für Anwendungen bei denen ein definierter Energieertrag wiederholbar erzeugt werden soll. Auch sind diese Ausführungsbeispiele vorteilhaft in Anwendungsfällen, bei denen es nicht auf den wiederholbar erzeugten Energieertrag, sondern beispielsweise eher auf eine einstellbare Haptik ankommt. Dies kann beispielsweise dadurch realisiert werden, dass die zu bewegende Komponente 10, 20 ohne Zwischenschaltung eines Federelementes von der Betätigungskraft unmittelbar beaufschlagbar ist. Damit hängt wie vorbeschrieben die Geschwindigkeit des Wechsels zwischen den Ruhestellungen Y1, Y3 von der Betätigungsgeschwindigkeit ab. Je größer die Betätigungsgeschwindigkeit ist, desto schneller wird die Relativbewegung durchgeführt, desto größer ist der erzeugbare Energieertrag, wobei der Wechsel von der Zwischenstellung Y2 in die Ruhestellung Y1, Y3 durch die jeweilige Sprungeinrichtung spürbar ist.

Mit Fig. 4 wird eine schematische Seitenansicht eines Induktionsgenerators 1 gemäß einer weiteren bevorzugten Ausführungsform in der der Zwischenstellung Y2 entsprechenden Position gezeigt. Der Induktionsgenerator 1 dieses Ausführungsbeispiels unterscheidet sich von dem mit den Fig. 1A bis 3 gezeigtem Induktionsgenerator 1 durch die Tatsache, dass auf das Gleitkontaktelement 30 verzichtet wurde. Der Induktionsgenerator 1 umfasst einen Spulenkern 11 mit einem Polkontaktabschnitt 15, der an der Polkontaktfläche 14 ein Ausmaß a hat, das größer als der zwischen der Nordpolkontaktfläche 26 und Südpolkontaktfläche 28 ausgebildete Abstand b ist. Die Polkontaktfläche 14 bildet hierbei einen Gleitkontaktflächenabschnitt mit einer Gleitkontaktfläche für das Magnetelement 20 aus. Entsprechend kontaktiert der Polkontaktabschnitt 15 wenigstens in der Zwischenstellung Y2 die Nordpolkontaktfläche 26 und die Südpolkontaktfläche 28, wodurch es zu einem temporären magnetischen Kurzschluss kommt. Die Relativbewegung zwischen Spulenkern 11 und dem Magnetelement 20 kann wegen des Verhältnisses zwischen dem Abstand a und b, das gleich oder größer als 1 ist, ohne einen Haptikeffekt erfolgen.

Die in den Fig. 1 bis 5 gezeigten Ausführungsformen sind für die Erfindung nicht einschränkend zu verstehen. Diese zeigen bevorzugte Ausführungsbeispiele der vorliegenden Erfindung. Weitere, unter den Gegenstand der Patentansprüche fallende Ausführungsformen sind denkbar. So kann beispielsweise in einem Ausführungsbeispiel das Gleitkontaktelement in einem zwischen den Südpolkontaktabschnitt und Nordpolkontaktabschnitt ausgebildeten Zwischenraum angeordnet sind, wobei eine Gleitkontaktfläche des Gleitkontaktabschnittes vorzugsweise in einer Ebene mit der Südpolkontaktfläche und der Nordpolkontaktfläche ist. Alternativ oder zusätzlich kann ein Gleitkontaktelement in einem zwischen den Polkontaktabschnitten des Spulenkerns ausgebildeten Zwischenraum angeordnet sein, wobei eine Gleitkontaktfläche des Gleitkontaktabschnittes vorzugsweise in einer Ebene mit den Polkontaktflächen der Polkontaktabschnitte liegt. Ferner ist der Spulenkern nicht auf eine U-förmige Gestalt beschränkt. So kann der Spulenkern weitere parallele Schenkel oder nur einen Schenkel aufweisen, wobei das Magnetelement entsprechend anzupassen ist. Grundsätzlich sind wenigstens zwei Polkontaktflächen notwendig, die mit der Südpolkontaktfläche und der Nordpolkontaktfläche derart in Kontakt bringbar sind, dass mittels Spulenumkehrpolung eine Induktionsspannung erzeugbar ist.

Ferner kann der Induktionsgenerator 1 zum Beispiel in einem Funkschalter verwendet werden, welcher eine Senderbaugruppe und eine Antennenbaugruppe mit einer Antenne aufweist. Der Induktionsgenerator 1 ist dabei z.B. mittels eines Kontaktelements zur Energieabgabe an die Senderbaugruppe mit dieser elektrisch kontaktierend verbunden, z.B. steckverbunden. Der Funkschalter kann dabei zusätzlich über ein wie vorbeschriebenes Federelement zur Erzwingung der Relativbewegung umfassen. Das Federelement kann weiterhin bevorzugt monostabil oder bistabil ausgebildet sein. Mit einem monostabilen Federelement wird die bewegbare Komponente nach einmaligem Betätigen des Funkschalters automatisch wieder in eine Ausgangsruhestellung versetzt. Das monostabile Federelement weist dazu vorzugsweise eine Rückstellfunktion auf, die integral mit dem Federelement ausgebildet ist. Mit einem bistabilen Federelement wird die bewegbare Komponente nach einmaligen Betätigen des Funkschalters von einer Ruhestellung in die andere Ruhestellung versetzt. Das bistabile Federelement ist vorzugsweise dergestalt, dass die bewegbare Komponente zwischen zwei Ruhestellungen wiederholbar bewegbar ist. Das monostabile als auch das bistabile Federelement können beispielsweise eine Blattfeder oder Spiralfeder sein.

### Bezugszeichen

- 1: Induktionsgenerator
- 10: erste Komponente
- 11: Spulenkern
- 12: erster Schenkel
- 13: zweiter Schenkel
- 14: Polkontaktfläche
- 15: Polkontaktabschnitt
- 16: Induktionsspule
- 17: Induktionsspulendurchgang
- 18: Polkontaktfläche
- 20: Magnetelement
- 21: Dauermagnet
- 22: erster Polschuh
- 23: zweiter Polschuh
- 24: Zwischenraum
- 25: Südpolkontaktabschnitt
- 26: Südpolkontaktfläche
- 27: Nordpolkontaktabschnitt
- 28: Nordpolkontaktfläche
- 30: Gleitkontaktelement
- 31: Gleitkontaktflächenabschnitt
- 32: Gleitkontaktfläche
- 33: Aussparung
- 34: Erhebung
- 35: Schenkel des Gleitkontaktelements
- a: Ausmaß Polkontaktabschnitt
- b: Ausmaß Zwischenraum
- B1: erster Magnetfluss
- B2: zweiter Magnetfluss
- X; Y: Bewegungsrichtung
- Y1: erste Ruhestellung
- Y2: Zwischenstellung
- Y3: zweite Ruhestellung

## Patentansprüche

1. Induktionsgenerator (1) für einen Funkschalter umfassend ein Magnetelement (20) mit zwei Magnetpolkontaktabschnitten (25, 27) oder mit einem von zwei Magnetpolkontaktabschnitten (25, 27) eingefassten dritten Magnetpolkontaktabschnitt (25; 27), wobei ein Magnetpolkontaktabschnitt einen Nordpolkontaktabschnitt (27) und ein dazu benachbarter einen Südpolkontaktabschnitt (25) ausbilden, und einen Spulenkern (11), der mit den Magnetpolkontaktabschnitten (25, 27) kontaktierbare Polkontaktabschnitte (15) aufweist, wobei die Anzahl der Polkontaktabschnitte (15) ungleich der Anzahl der Magnetpolkontaktabschnitte (25, 27) ist, wobei das Magnetelement (20) und der Spulenkern (11) zueinander relativ beweglich derart angeordnet sind, dass eine Magnetflussrichtungsumkehr in dem Spulenkern (11) bei Wechsel zwischen einer eine Bewegungsrichtung (X; Y) für die Relativbewegung definierenden ersten (Y1) und zweiten Ruhestellung (Y3) erzeugbar ist, wobei in jeder der Ruhestellungen (Y1, Y3) ein Nordpol- (27) und Südpolkontaktabschnitt (25) jeweilig zugeordnete Polkontaktabschnitte (15) derart kontaktieren, dass in der ersten Ruhestellung (Y1) in dem Spulenkern (11) ein Magnetfluss mit einer ersten Richtung erzeugbar ist, welcher einer zweiten Richtung eines in dem Spulenkern (11) in der zweiten Ruhestellung (Y2) erzeugbaren Magnetflusses entgegengesetzt ist, **dadurch gekennzeichnet, dass** der Spulenkern (11) zwei oder drei Polkontaktabschnitte (15) aufweist; und der Induktionsgenerator (1) einen sich parallel zu der Bewegungsrichtung (X; Y) erstreckenden magnetisierbaren Gleitkontaktabschnitt (31) zur gleitenden Führung der Relativbewegung zwischen Spulenkern (11) und Magnetelement (20) unter Beibehaltung eines zwischen Spulenkern (11) und Magnetelement (20) bestehenden magnetischen Kontakts aufweist.

2. Induktionsgenerator (1) nach Anspruch 1, **dadurch gekennzeichnet, dass** der Gleitkontaktabschnitt (31) derart ausgebildet ist, dass dieser gleichzeitig den Nordpolkontaktabschnitt (27) und den Südpolkontaktabschnitt (25) wenigstens in einer zwischen der ersten (Y1) und zweiten Ruhestellung (Y3) definierten Zwischenstellung (Y2) kontaktiert.

3. Induktionsgenerator (1) nach Anspruch 1 oder 2, **dadurch gekennzeichnet, dass** der Gleitkontaktabschnitt (31) wenigstens einen der Polkontaktabschnitte (15) umfasst, und dass sich der Gleitkontaktabschnitt (31) parallel zu der Bewegungsrichtung (X; Y) derart erstreckt, dass wenigstens in der Zwischenstellung (Y2) ein zwischen dem Nordpolkontaktabschnitt (27) und dem Südpolkontaktabschnitt (25) definierter Zwischenraum (24), von dem Gleitkontaktabschnitt (31) überdeckbar ist.

4. Induktionsgenerator (1) nach Anspruch 3, **dadurch gekennzeichnet, dass** der Induktionsgenerator (1 ein Gleitkontaktelement umfasst, das einen an dem wenigstens einen Polkontaktabschnitt (15) angrenzenden Gleitkontaktteilabschnitt aufweist, wobei der Gleitkontaktteilabschnitt mit dem wenigstens einen Polkontaktabschnitt (15) den Gleitkontaktabschnitt (31) ausbildet.

5. Induktionsgenerator (1) nach Anspruch 4, **dadurch gekennzeichnet, dass** das Gleitkontaktelement eine Aussparung zur Einfassung des wenigstens einen Polkontaktabschnitts (15) aufweist.

6. Induktionsgenerator (1) nach Anspruch 1, **dadurch gekennzeichnet, dass** der Induktionsgenerator (1) ein den Gleitkontaktabschnitt (31) ausbildendes Gleitkontaktelement (30) aufweist, wobei der Gleitkontaktabschnitt (31) wenigstens in einem Bereich eines zwischen dem Nordpolkontaktabschnitt (27) und dem Südpolkontaktabschnitt (25) definierten Zwischenraums (24) angeordnet ist und den Nordpolkontaktabschnitt (27) mit dem Südpolkontaktabschnitt (25) verbindet.

7. Induktionsgenerator (1) nach Anspruch 6, **dadurch gekennzeichnet, dass** das Gleitkontaktelement (30) eine Aussparung zur Einfassung wenigstens des Nordpol- (27) oder Südpolkontaktabschnitts (25) aufweist.

8. Induktionsgenerator (1) nach Anspruch 1, **dadurch gekennzeichnet, dass** der Induktionsgenerator (1) ein den Gleitkontaktabschnitt (31) ausbildendes Gleitkontaktelement (30) umfasst, das zwischen dem Spulenkern (11) und dem Magnetelement (20) zur Anlage des Gleitkontaktabschnitts (31) an den Polkontaktabschnitten (15) und den Magnetpolkontaktabschnitten (25, 27) in der ersten Ruhestellung (Y1), der zweiten Ruhestellung (Y3) und der Zwischenstellung (Y2) angeordnet ist.

9. Induktionsgenerator (1) nach einem der Ansprüche 4 bis 8, **dadurch gekennzeichnet, dass** das Gleitkontaktelement (30) ein Feinblech oder eine Folie aus einem magnetisierbaren Material ist.

10. Induktionsgenerator (1) nach Anspruch 8 oder 9, **dadurch gekennzeichnet, dass** der Gleitkontaktabschnitt (31) wenigstens eine Aussparung (33) in einem Bereich zwischen dem Nordpolkontaktabschnitt (25) und dem Südpolkontaktabschnitt (27) zur Verringerung eines Querschnitts des Gleitkontaktelementes (30) in diesem Bereich aufweist.

11. Induktionsgenerator (1) nach einem der Ansprüche 2 bis 10, **dadurch gekennzeichnet, dass** der Gleitkontaktabschnitt (31) einen gleichen oder höheren magnetischen Leitfähigkeitswert als eine für den Kontakt mit dem Nord- (27) und Südpolkontaktabschnitt (25) zugeordnete Polkontakffläche (14) aufweist.

12. Induktionsgenerator (1) nach einem der vorhergehenden Ansprüche, **dadurch gekennzeichnet, dass** der Induktionsgenerator (1) wenigstens eine Sprungeinrichtung (a, b; 34) umfasst, mittels welcher die Relativbewegung zwischen Spulenkern (11) und Magnetelement (20) unabhängig von einer die Relativbewegung bewirkenden Betätigungskraft und einer damit einhergehenden Betätigungsgeschwindigkeit mit gleich bleibendem vorbestimmbaren Wert beschleunigbar ist.

13. Induktionsgenerator (1) nach Anspruch 12, **dadurch gekennzeichnet, dass** die Sprungeinrichtung (a, b; 34) zwischen der ersten (Y1) und zweiten Ruhestellung (Y3), insbesondere in einem der Zwischenstellung (Y2) entsprechenden Bereich zwischen dem Nordpol- (27) und Südpolkontaktabschnitt (25) wirksam ist.

14. Induktionsgenerator (1) nach Anspruch 13, **dadurch gekennzeichnet, dass** die Sprungeinrichtung (a, b; 34) entweder einen ersten Abstand (a) und einen zweiten Abstand (b) mit einem Verhältnis des ersten Abstandes (a) zu dem zweiten Abstand (b) von ≤ 1 umfasst, wobei der erste Abstand (a) einer parallel zu der Relativbewegungsrichtung (X; Y) verlaufenden Erstreckung einer von dem Polkontaktabschnitt (15) ausgebildeten Polkontaktfläche (14) entspricht, wobei der zweite Ab stand (b) einer parallel zu der Relativbewegungsrichtung (X; Y) verlaufenden Erstreckung eines zwischen dem Südpolkontaktabschnitt (22) und dem Nordpolkontakfabschnitt (23) ausgebildeten Zwischenraums (24) entspricht; oder eine mit dem Gleitkontaktelement (30) ausgebildete Erhebung (34) aufweist.

15. Funkschalter mit einer Senderbaugruppe und einer Antenne, **dadurch gekennzeichnet, dass** der Funkschalter einen Induktionsgenerator (1) nach einem der vorhergehenden Ansprüche aufweist.

## Claims

1. Induction generator (1) for a radio-controlled switch comprising a magnet element (20) having two magnet pole contact sections (25, 27) or having a third magnet pole contact section (25, 27), which is surrounded by two magnet pole contact sections (25, 27), wherein one magnet pole contact section forms a north pole contact section (27) and a magnet pole contact section adjacent thereto forms a south pole contact section (25), and a coil core (11), which has pole contact sections (15) which can be brought into contact with the magnet pole contact sections (25, 27), wherein the number of pole contact sections (15) is unequal to the number of magnet pole contact sections (25, 27), wherein the magnet element (20) and the coil core (11) are arranged so as to be movable relative to one another in such a way that a magnetic flux direction reversal can be generated in the coil core (11) in the event of a change between a first rest position (Y1) and a second rest position (Y3), which each define a movement direction (X; Y) for the relative movement, wherein, in each of the rest positions (Y1, Y3) a north pole contact section (27) and a south pole contact section (25) make contact with respectively assigned pole contact sections (15) in such a way that, in the first rest position (Y1), a magnetic flux with a first direction can be generated in the coil core (11), which magnetic flux is opposite to a second direction of a magnetic flux which can be generated in the coil core (11) in the second rest position (Y2), **characterized in that** the coil core (11) has two or three pole contact sections (15), and the induction generator (1) has a magnetisable sliding contact section (31), which extends parallel to the movement direction (X; Y), for the sliding guidance of the relative movement between the coil core (11) and the magnet element (20) while maintaining a magnetic contact existing between the coil core (11) and the magnet element (20).

2. Induction generator (1) according to Claim 1, **characterized in that** the sliding contact section (31) is designed in such a way that it simultaneously makes contact with the north pole contact section (27) and the south pole contact section (25) at least in an intermediate position (Y2) which is defined between the first rest position (Y1) and the second rest position (Y3).

3. Induction generator (1) according to Claim 1 or 2, **characterized in that** the sliding contact section (31) comprises at least one of the pole contact sections (15), and **in that** the sliding contact section (31) extends parallel to the movement direction (X; Y) in such a way that, at least in the intermediate position (Y2), an interspace (24) defined between the north pole contact section (27) and the south pole contact section (25) can be covered by the sliding contact section (31).

4. Induction generator (1) according to Claim 3, **characterized in that** the induction generator (1) comprises a sliding contact element, which has a sliding contact subsection adjoining the at least one pole contact section (15), wherein the sliding contact subsection forms, with the at least one pole contact section (15), the sliding contact section (31).

5. Induction generator (1) according to Claim 4, **characterized in that** the sliding contact element has a cutout for enclosing the at least one pole contact section (15).

6. Induction generator (1) according to Claim 1, **characterized in that** the induction generator (1) has a sliding contact element (30) forming the sliding contact section (31), wherein the sliding contact section (31) is arranged at least in a region of an interspace (24) defined between the north pole contact section (27) and the south pole contact section (25) and connects the north pole contact section (27) to the south pole contact section (25).

7. Induction generator (1) according to Claim 6, **characterized in that** the sliding contact element (30) has a cutout for enclosing at least the north pole contact section (27) or the south pole contact section (25).

8. Induction generator (1) according to Claim 1, **characterized in that** the induction generator (1) comprises a sliding contact element (30) forming the sliding contact section (31), said sliding contact element being arranged between the coil core (11) and the magnet element (20) such that the sliding contact section (31) bears against the pole contact section (15) and the magnet pole contact sections (25, 27) in the first rest position (Y1), the second rest position (Y3) and the intermediate position (Y2).

9. Induction generator (1) according to one of Claims 4 to 8, **characterized in that** the sliding contact element (30) is a fine metal sheet or a film consisting of a magnetisable material.

10. Induction generator (1) according to Claim 8 or 9, **characterized in that** the sliding contact section (31) has at least one cutout (33) in a region between the north pole contact section (25) and the south pole contact section (27) for reducing a cross section of the sliding contact element (30) in this region.

11. Induction generator (1) according to one of Claims 2 to 10, **characterized in that** the sliding contact section (31) has a magnetic conductivity value which is equal to or greater than that of a pole contact face (14) assigned for the contact to the north pole contact section (27) and the south pole contact section (25).

12. Induction generator (1) according to one of the preceding claims, **characterized in that** the induction generator (1) comprises at least one jump device (a, b; 34), by means of which the relative movement between the coil core (11) and the magnet element (20) can be accelerated independently of an actuating force effecting the relative movement and an actuating speed associated therewith, with the predeterminable value remaining the same.

13. Induction generator (1) according to Claim 12, **characterized in that** the jump device (a, b; 34) is effective between the first rest position (Y1) and the second rest position (Y3), in particular in a region corresponding to the intermediate position (Y2) between the north pole contact section (27) and the south pole contact section (25).

14. Induction generator (1) according to Claim 13, **characterized in that** the jump device (a, b; 34) either comprises a first spacing (a) and a second spacing (b) with a ratio of the first spacing (a) to the second spacing (b) of ≤ 1, wherein the first spacing (a) corresponds to an extension of a pole contact face (14) formed by the pole contact section (15) which runs parallel to the relative movement direction (X; Y), wherein the second spacing (b) corresponds to an extension of interspace (24) formed between the south pole contact section (22) and the north pole contact section (23) which runs parallel to the relative movement direction (X; Y) or has an elevation (34) formed with the sliding contact element (30).

15. Radio-controlled switch comprising a transmitter assembly and an antenna, **characterized in that** the radio-controlled switch has an induction generator (1) according to one of the preceding claims.

## Revendications

1. Générateur à induction (1) pour un commutateur radio comprenant un élément magnétique (20) avec deux parties de contact de pôle magnétique (25, 27) ou avec une troisième partie de contact de pôle magnétique (25 ; 27) enchâssée par deux parties de contact de pôle magnétique (25, 27), une partie de contact de pôle magnétique formant une partie de contact de pôle nord (27) et une partie de contact de pôle magnétique adjacente à celle-ci formant une partie de contact de pôle sud (25), et un noyau de bobine (11) présentant des parties de contact de pôle (15) pouvant entrer en contact avec les parties de contact de pôle magnétique (25, 27), le nombre de parties de contact de pôle (15) étant différent du nombre de parties de contact de pôle magnétique (25, 27), l'élément magnétique (20) et le noyau de bobine (11) étant disposés de manière mobile l'un par rapport à l'autre de manière à ce qu'une inversion de la direction du flux magnétique dans le noyau de bobine (11) puisse être provoquée en cas de changement entre une première (Y1) et une deuxième position de repos (Y3) définissant une direction de déplacement (X ; Y) pour le déplacement relatif, dans chacune des positions de repos (Y1, Y3), une partie de contact de pôle nord (27) et une partie de contact de pôle sud (25) entrant en contact avec des parties de contact de pôle (15) respectivement associées de manière à ce que dans la première position de repos (Y1), il est possible de générer dans le noyau de bobine (11) un flux magnétique d'une première direction, lequel est opposé à une deuxième direction d'un flux magnétique pouvant être généré dans le noyau de bobine (11) dans la deuxième position de repos (Y2), **caractérisé en ce que** le noyau de bobine (11) présente deux ou trois parties de contact de pôle (15) ; et **en ce que** le générateur à induction (1) présente une partie de contact de glissement (31) magnétisable s'étendant parallèlement à la direction de déplacement (X ; Y) pour le guidage par glissement du déplacement relatif entre le noyau de bobine (11) et l'élément magnétique (20) tout en conservant un contact magnétique existant entre le noyau de bobine (11) et l'élément magnétique (20).

2. Générateur à induction (1) selon la revendication 1, **caractérisé en ce que** la partie de contact de glissement (31) est réalisée de manière à ce que celle-ci entre simultanément en contact avec la partie de contact de pôle nord (27) et la partie de contact de pôle sud (25) au moins dans une position intermédiaire (Y2) définie entre la première (Y1) et la deuxième position de repos (Y3).

3. Générateur à induction (1) selon la revendication 1 ou 2, **caractérisé en ce que** la partie de contact de glissement (31) comprend au moins l'une des parties de contact de pôle (15), et **en ce que** la partie de contact de glissement (31) s'étend parallèlement à la direction de déplacement (X ; Y) de manière à ce qu'au moins dans la position intermédiaire (Y2), un espace intermédiaire (24) défini entre la partie de contact de pôle nord (27) et la partie de contact de pôle sud (25) puisse être recouvert par la partie de contact de glissement (31).

4. Générateur à induction (1) selon la revendication 3, **caractérisé en ce que** le générateur à induction (1) comprend un élément de contact de glissement qui présente une partie partielle de contact de glissement jouxtant l'au moins une partie de contact de pôle (15), la partie partielle de contact de glissement formant, avec l'au moins une partie de contact de pôle (15), la partie de contact de glissement (31).

5. Générateur à induction (1) selon la revendication 4, **caractérisé en ce que** l'élément de contact de glissement présente un évidement pour l'enchâssement de l'au moins une partie de contact de pôle (15).

6. Générateur à induction (1) selon la revendication 1, **caractérisé en ce que** le générateur à induction (1) présente un élément de contact de glissement (30) formant la partie de contact de glissement (31), la partie de contact de glissement (31) étant disposée au moins dans une zone d'un espace intermédiaire (24) défini entre la partie de contact de pôle nord (27) et la partie de contact de pôle sud (25) et reliant la partie de contact de pôle nord (27) à la partie de contact de pôle sud (25).

7. Générateur à induction (1) selon la revendication 6, **caractérisé en ce que** l'élément de contact de glissement (30) présente un évidement pour l'enchâssement au moins de la partie de contact de pôle nord (27) ou de la partie de contact de pôle sud (25).

8. Générateur à induction (1) selon la revendication 1, **caractérisé en ce que** le générateur à induction (1) comprend un élément de contact de glissement (30) formant la partie de contact de glissement (31), lequel est disposé entre le noyau de bobine (11) et l'élément magnétique (20) afin que la partie de contact de glissement (31) repose contre les parties de contact de pôle (15) et les parties de contact de pôle magnétique (25, 27) dans la première position de repos (Y1), la deuxième position de repos (Y3) et la position intermédiaire (Y2).

9. Générateur à induction (1) selon l'une des revendications 4 à 8, **caractérisé en ce que** l'élément de contact de glissement (30) est une tôle mince ou une feuille en un matériau magnétisable.

10. Générateur à induction (1) selon la revendication 8 ou 9, **caractérisé en ce que** la partie de contact de glissement (31) présente au moins un évidement (33) dans une zone entre la partie de contact de pôle nord (25) et la partie de contact de pôle sud (27) pour réduire une section transversale de l'élément de contact de glissement (30) dans cette zone.

11. Générateur à induction (1) selon l'une des revendications 2 à 10, **caractérisé en ce que** la partie de contact de glissement (31) présente une valeur de capacité conductrice magnétique égale ou supérieure à celle d'une surface de contact de pôle (14) associée pour le contact avec la partie de contact de pôle nord (27) et la partie de contact de pôle sud (25).

12. Générateur à induction (1) selon l'une des revendications précédentes, **caractérisé en ce que** le générateur à induction (1) comprend au moins un dispositif de détente (a, b ; 34) au moyen duquel le déplacement relatif entre le noyau de bobine (11) et l'élément magnétique (20) peut être accéléré indépendamment d'une force d'actionnement provoquant le déplacement relatif et d'une vitesse d'actionnement inhérente à celle-ci, avec une valeur prédéfinissable restant identique.

13. Générateur à induction (1) selon la revendication 12, **caractérisé en ce que** le dispositif de détente (a, b ; 34) agit entre la première (Y1) et la deuxième position de repos (Y3), en particulier dans une zone, correspondant à la position intermédiaire (Y2), entre la partie de contact de pôle nord (27) et la partie de contact de pôle sud (25).

14. Générateur à induction (1) selon la revendication 13, **caractérisé en ce que** le dispositif de détente (a, b ; 34) comprend une première distance (a) et une deuxième distance (b) avec un rapport entre la première distance (a) et la deuxième distance (b) ≤ 1, la première distance (a) correspondant à une étendue s'étendant parallèlement à la direction de déplacement relatif (X ; Y) d'une surface de contact de pôle (14) formée par la partie de contact de pôle (15), la deuxième distance (b) correspondant à une étendue s'étendant parallèlement à la direction de déplacement relatif (X ; Y) d'un espace intermédiaire (24) formé entre la partie de contact de pôle sud (22) et la partie de contact de pôle nord (23) ; ou bien présente une bosse (34) formée avec l'élément de contact de glissement (30).

15. Commutateur radio avec un module d'émetteur et une antenne, **caractérisé en ce que** le commutateur radio présente un générateur à induction (1) selon l'une des revendications précédentes.
